(19) **Europäisches Patentamt / European Patent Office / Office européen des brevets**

(11) **EP 4 541 926 A1**

(12) **EUROPEAN PATENT APPLICATION**
published in accordance with Art. 153(4) EPC

(43) Date of publication:
23.04.2025 Bulletin 2025/17

(21) Application number: 23842184.6

(22) Date of filing: 12.07.2023

(51) International Patent Classification (IPC):
$C23C\ 14/16^{(2006.01)}$

(52) Cooperative Patent Classification (CPC):
B01D 71/02231; B01D 53/22; C01B 3/32;
C01B 3/505; C01B 15/029; C01C 1/04; C22F 1/02;
C22F 1/14; C23C 14/16; C23C 14/18; C23C 14/20;
C23C 16/06; C23C 18/42; B01D 2323/50

(86) International application number:
PCT/CN2023/107040

(87) International publication number:
WO 2024/017119 (25.01.2024 Gazette 2024/04)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 18.07.2022 CN 202210843326

(71) Applicants:
• China Petroleum & Chemical Corporation
Beijing 100728 (CN)
• Sinopec Research Institute of Safety
Engineering Co., Ltd.
Qingdao, Shandong 266104 (CN)

(72) Inventors:
• ZHAO, Chenyang
Qingdao, Shandong 266104 (CN)
• SUN, Bing
Qingdao, Shandong 266104 (CN)
• LIU, Yujia
Qingdao, Shandong 266104 (CN)
• JIANG, Jie
Qingdao, Shandong 266104 (CN)
• ZHU, Yunfeng
Qingdao, Shandong 266104 (CN)
• XU, Wei
Qingdao, Shandong 266104 (CN)
• YANG, Zhe
Qingdao, Shandong 266104 (CN)

(74) Representative: Hoffmann Eitle
Patent- und Rechtsanwälte PartmbB
Arabellastraße 30
81925 München (DE)

(54) **TARGET PALLADIUM MEMBRANE SELECTION METHOD, HYDROGEN-RELATED REACTION EXECUTION METHOD, OSMOSIS DIFFUSION RATE DETERMINATION METHOD AND SYSTEM**

(57) The present invention discloses a target palladium membrane selection method, a hydrogen-related reaction execution method, and an osmosis diffusion rate determination method and system. The selection method comprises : according to a target osmosis diffusion rate of hydrogen gas passing through a target palladium membrane, a target thickness of the target palladium membrane, and a corresponding relationship between the permeation diffusion rate of hydrogen gas passing through a sample palladium membrane and a specific parameter group of the sample palladium membrane, determining target lattice parameters of the target palladium membrane, and target metal components and proportions thereof; and selecting as a target palladium membrane a palladium membrane having the target lattice parameters, the target metal components and proportions thereof, and the target thickness. The present invention allows for efficiently and conveniently selecting a suitable palladium membrane for satisfying a target hydrogen osmosis diffusion rate of a hydrogen-related reaction, conveniently measuring the hydrogen osmosis diffusion rate of a palladium membrane, and accurately controlling a hydrogen-related reaction.

S101 | A target lattice parameter, and target metal components and a ratio thereof of the target palladium membrane are determined according to a target permeation and diffusion rate of hydrogen passing through the target palladium membrane, a target thickness of the target palladium membrane, and a correspondence between a permeation and diffusion rate of hydrogen passing through a sample palladium membrane and a specific parameter set of the sample palladium membrane

S102 | A palladium membrane having the target lattice parameter, the target metal components and the ratio thereof, and the target thickness is selected to be the target palladium membrane

FIG. 1

**Description**

**Cross Reference to Related Applications**

This application claims the benefit of Chinese patent application 202210843326.5, filed on July 18, 2022, the contents of which are incorporated herein by reference.

**Field of the Invention**

The present invention relates to the technical field of hydrogen purification, in particular to a selection method and system for a target palladium membrane, an execution method and system for a hydrogen-related reaction, and a determination method and system for a permeation rate.

**Background of the Invention**

Hydrogen permeation rates required for different hydrogen-related reactions are different, so influencing factors of the hydrogen permeation rate is also an important research topic of researchers. Currently, researchers have studied that the influencing factors of the hydrogen permeation rates include a thickness of a palladium membrane, a carrier porosity, surface defect control and the like. However, these research topics are also of great significance by which influencing factors can more accurately characterize the hydrogen permeation rate, and how to screen a suitable palladium membrane to meet a target hydrogen permeation rate for the hydrogen-related reaction.

In addition, the existing method for detecting the hydrogen permeation rate is mainly by flow calibration, and detection steps include: (1) after a palladium membrane to be tested is sealed by a graphite ferrule, metal welding, ceramic glaze sealing, etc., for the sealed palladium membrane is placed in a fixed-bed reactor test apparatus, and a sealed gas permeation and diffusion test device is constructed. (2) Hydrogen is introduced from a gas inlet side, and a certain transmembrane pressure is maintained. Combined with the Fick's law, a flow rate (F) of hydrogen passing through the palladium membrane to a permeation side within a certain time (t) is determined. (3) conversion is performed to obtain the hydrogen permeation rate (J), wherein J=F/t.

In the above test process, due to the different sealing methods and sealing positions in the sealing process of the palladium membrane, a defect exposure degree may be different after the palladium membrane is sealed, which may lead to the difference of the hydrogen permeation rate at a defect, thus affecting the test accuracy of the hydrogen permeation rate. At the same time, the overall sealing performance of the test device will also affect the stability of the transmembrane pressure, and the transmembrane pressure is a driving force for hydrogen permeation and diffusion on the palladium membrane. Thus, the sealing performance of the apparatus and the device is also a factor affecting the permeation rate of a membrane material.

At the same time, there are great occasional differences in the observation of the time and a flow rate by different testers. To sum up, the existing test system has many systematic errors and accidental errors, has high demands on equipment, raw materials and testing personnel, and is time-consuming and labor-consuming in a testing process.

**Summary of the Invention**

An object of the present invention is to provide a selection method and system for a target palladium membrane, an execution method and system for a hydrogen-related reaction, and a determination method and system for a permeation rate, which can efficiently and conveniently select an appropriate palladium membrane to satisfy a target hydrogen permeation rate of a hydrogen-related reaction, can conveniently determine a hydrogen permeation rate of a palladium membrane, and can accurately control the progress of the hydrogen-related reaction so that its hydrogen permeation rate satisfies a target value.

According to a first aspect of the present invention, provided is a selection method for a target palladium membrane, including: determining a target lattice parameter, and target metal components and a ratio thereof of the target palladium membrane according to a target permeation rate of hydrogen passing through the target palladium membrane, a target thickness of the target palladium membrane, and a correspondence between a permeation rate of hydrogen passing through a sample palladium membrane and a specific parameter set of the sample palladium membrane, wherein the specific parameter set includes a lattice parameter, a metal composition coefficient and a thickness; and selecting a palladium membrane having the target lattice parameter, the target metal components and the ratio thereof, and the target thickness to be the target palladium membrane.

In the embodiment of the present application, the correspondence between the permeation rate of the hydrogen passing through the sample palladium membrane and the specific parameter set of the sample palladium membrane comprises:

$$J_{H2} = \frac{A}{k \times d},$$

wherein $J_{H2}$ is the permeation rate of the hydrogen passing through the sample palladium membrane; k is a lattice parameter of the sample palladium membrane; d is a thickness of the sample palladium membrane; and A is a metal composition coefficient of the sample palladium membrane.

In the embodiment of the present application, the correspondence between the permeation rate of the hydrogen passing through the sample palladium membrane and the specific parameter set of the sample palladium membrane comprises:

$$J_{H2} = \frac{A}{b \times k \times d},$$

wherein $J_{H2}$ is the permeation rate of the hydrogen passing through the sample palladium membrane; k is a lattice parameter of the sample palladium membrane; d is a thickness of the sample palladium membrane; A is a metal composition coefficient of the sample palladium membrane; and b is a correction coefficient.

In the embodiment of the present application, A depends on the number of metal species of the sample palladium membrane, a relative atomic mass and a density of each metal, and an average relative atomic mass and an average density of the sample palladium membrane.

In the embodiment of the present application, A is determined by:

$$A = (n-1)! \times \frac{\left[\frac{M_a^n}{\sum_i^n M_i}\right]^{\frac{1}{n}} \times \left[\frac{\sum_i^n \rho_i}{\rho_a^n}\right]^{\frac{1}{n}}}{10^5},$$

wherein n is the number of metal species of the sample palladium membrane, $M_i$ and $\rho_i$ are a relative atomic mass and a density of an ith metal of the sample palladium membrane, respectively, and $M_a$ and $\rho_a$ are an average relative atomic mass and an average density of the sample palladium membrane, respectively.

In the embodiment of the present application, b depends on an effective atomic radius of the sample palladium membrane.

In the embodiment of the present application, in a case where a material of the sample palladium membrane is a PdCu alloy, b is in the range of 1.01-2.51; in a case where a material of the sample palladium membrane is a PdAg alloy, b is in the range of 1.12-2.53; in a case where a material of the sample palladium membrane is a PdAu alloy, b is in the range of 1.56-3.62; in a case where a material of the sample palladium membrane is a PdCuAg alloy, b is in the range of 1.93-3.69; in a case where a material of the sample palladium membrane is a PdCuAu alloy, b is in the range of 2.56-4.99; or in a case where a material of the sample palladium membrane is a PdCuNi alloy, b is in the range of 1.63-2.71.

Through the above technical solution, the present invention inventively first determines the target lattice parameter, and the target metal components and the ratio thereof of the target palladium membrane according to the target permeation rate of the hydrogen passing through the target palladium membrane, the target thickness of the target palladium membrane, and the correspondence between the permeation rate of the hydrogen passing through the sample palladium membrane and the specific parameter set of the sample palladium membrane; and then selects the palladium membrane having the target lattice parameter, the target metal components and the ratio thereof, and the target thickness to be the target palladium membrane. In the present invention, an appropriate palladium membrane can be efficiently and conveniently selected to satisfy a target hydrogen permeation rate of a hydrogen-related reaction.

According to a second aspect of the present invention, provided is an execution method for a hydrogen-related reaction, including: selecting one or more target palladium membranes according to a selection method for a target palladium membrane for a hydrogen-related reaction, wherein a permeation rate of hydrogen passing through any one of the one or more target palladium membranes is a target permeation rate; and executing the hydrogen-related reaction with one of the one or more target palladium membranes.

In the embodiment of the present application, the hydrogen-related reaction is a reaction in which hydrogen, oxygen and propene are used as substrates to synthesize propylene oxide; the hydrogen-related reaction is a reaction in which hydrogen and oxygen are used as substrates to synthesize hydrogen peroxide; the hydrogen-related reaction is a reaction for hydrogen production by steam reforming of alcohol and water; the hydrogen-related reaction is a carbon dioxide hydrogenation reaction; the hydrogen-related reaction is a reaction in which hydrogen and nitrogen are used as substrates to synthesize ammonia gas; the hydrogen-related reaction is a reaction in which ethane is dehydrogenated to prepare ethylene; the hydrogen-related reaction is a reaction in which propane is dehydrogenated to prepare propylene; the hydrogen-related reaction is a reaction in which butane is dehydrogenated to form butadiene; the hydrogen-related reaction is a reaction in which isopentene is dehydrogenated to form isoprene; the hydrogen-related reaction is a reaction in which ethylbenzene is dehydrogenated to prepare styrene; the hydrogen-related reaction is a reaction in which isobutane is dehydrogenated to prepare isobutylene; the hydrogen-related reaction is a reaction in which benzene is hydrogenated to prepare cyclohexane; the hydrogen-related reaction is a reaction in which benzene, hydrogen, and oxygen are used as substrates to prepare phenol; the hydrogen-related reaction is a reaction in which carbon monoxide is hydrogenated to prepare methanol; the hydrogen-related reaction is a reaction in which phenol is hydrogenated to prepare cyclohexanol; the hydrogen-related reaction is a reaction in which nitrobenzene is subjected to hydrogenation reduction to prepare aniline; or the hydrogen-related reaction is a reaction in which butane is dehydrogenated to form butadiene.

In the embodiment of the present application, the target palladium membrane is prepared by: performing alloying treatment on a palladium membrane raw material under different conditions of the alloying treatment, measuring a lattice parameter of a product, and establishing a fitting curve of a correspondence between conditions of the alloying treatment and the lattice parameter; determining a target condition of the alloying treatment according to a lattice parameter of the target palladium membrane and the fitting curve; and performing alloying treatment on the palladium membrane raw material by using the target condition to obtain the target palladium membrane.

Through the above technical solution, the present invention inventively first selects the target palladium membranes for the hydrogen-related reaction according to the selection method for the target palladium membrane for the hydrogen-related reaction; then executes the hydrogen-related reaction with one of the selected target palladium membranes, and thus, the method of the present invention can accurately control the progress of the hydrogen-related reaction so that its hydrogen permeation rate satisfies the target value.

According to a third aspect of the present invention, provided is a determination method for a permeation rate, including: measuring a lattice parameter of a palladium membrane; and determining a permeation rate of hydrogen passing through the palladium membrane according to a lattice parameter, and metal components and a ratio thereof, and a thickness of the palladium membrane, and a correspondence between a permeation rate of hydrogen passing through a sample palladium membrane and a specific parameter set of the sample palladium membrane, wherein the specific parameter set includes a lattice parameter, a metal composition coefficient, and a thickness.

In the embodiment of the present application, the correspondence between the permeation rate of the hydrogen passing through the sample palladium membrane and the specific parameter set of the sample palladium membrane comprises:

$$J_{H2} = \frac{A}{k \times d},$$

wherein $J_{H2}$ is the permeation rate of the hydrogen passing through the sample palladium membrane; k is a lattice parameter of the sample palladium membrane; d is a thickness of the sample palladium membrane; and A is a metal composition coefficient of the sample palladium membrane.

In the embodiment of the present application, the correspondence between the permeation rate of the hydrogen passing through the sample palladium membrane and the specific parameter set of the sample palladium membrane comprises:

$$J_{H2} = \frac{A}{b \times k \times d},$$

wherein $J_{H2}$ is the permeation rate of the hydrogen passing through the sample palladium membrane; k is a lattice parameter of the sample palladium membrane; d is a thickness of the sample palladium membrane; A is a metal composition coefficient of the sample palladium membrane; and b is a correction coefficient.

In the embodiment of the present application, A depends on the number of metal species of the sample palladium membrane, a relative atomic mass and a density of each metal, and an average relative atomic mass and an average density of the sample palladium membrane.

In the embodiment of the present application, A is determined by:

$$A = (n-1)! \times \frac{\left[\frac{M_a^n}{\sum_i^n M_i}\right]^{\frac{1}{n}} \times \left[\frac{\sum_i^n \rho_i}{\rho_a^n}\right]^{\frac{1}{n}}}{10^5},$$

wherein n is the number of metal species of the sample palladium membrane, $M_i$ and $\rho_i$ are a relative atomic mass and a density of an ith metal of the sample palladium membrane, respectively, and $M_a$ and $\rho_a$ are an average relative atomic mass and an average density of the sample palladium membrane, respectively.

In the embodiment of the present application, b depends on an effective atomic radius of the sample palladium membrane.

Through the above technical solution, the present invention inventively first measures the lattice parameter of the palladium membrane; then determines the permeation rate of the hydrogen passing through the palladium membrane according to the lattice parameter, and the metal components and the ratio thereof, and the thickness of the palladium membrane, and the correspondence between the permeation rate of the hydrogen passing through the sample palladium membrane and the specific parameter set of the sample palladium membrane. Thus, the method of the present invention can efficiently and accurately determine the hydrogen permeation rate of the palladium membrane under non-destructive treatment conditions.

According to a fourth aspect of the present invention, provided is a selection system for a target palladium membrane, including: a memory configured to store a target permeation rate of hydrogen passing through the target palladium membrane, a target thickness of the target palladium membrane, and a correspondence between a permeation rate of hydrogen passing through a sample palladium membrane and a specific parameter set of the sample palladium membrane, wherein the specific parameter set includes a lattice parameter, a metal composition coefficient, and a thickness; and a processor configured to: determine a target lattice parameter, and target metal components and a ratio thereof of the target palladium membrane according to the target permeation rate, the target thickness, and the correspondence; and select a palladium membrane having the target lattice parameter, the target metal components and the ratio thereof, and the target thickness to be the target palladium membrane.

Specific details and benefits of the selection system for the target palladium membrane provided by the present invention can refer to the above description of the selection method for the target palladium membrane, which will not be repeated here.

According to a fifth aspect of the present invention, provided is an execution system for a hydrogen-related reaction, including: a selection system for a target palladium membrane, configured to select one or more target palladium membranes for the hydrogen-related reaction, wherein a permeation rate of hydrogen passing through any one of the one or more target palladium membranes is a target permeation rate; and an execution device configured to execute the hydrogen-related reaction with one of the one or more target palladium membranes.

Specific details and benefits of the execution system for the hydrogen-related reaction provided by the present invention can refer to the above description of the execution method for the hydrogen-related reaction, which will not be repeated here.

According to a sixth aspect of the present invention, provided is a determination system for a permeation rate, including: a measuring device configured to measure a lattice parameter of a palladium membrane; a memory configured to store metal components and a ratio thereof, and a thickness of the palladium membrane; and a processor configured to determine a permeation rate of hydrogen passing through the palladium membrane according to the lattice parameter, and the metal components and the ratio thereof, and the thickness of the palladium membrane, and a correspondence between a permeation rate of hydrogen passing through a sample palladium membrane and a specific parameter set of the sample palladium membrane, wherein the specific parameter set includes a lattice parameter, a metal composition coefficient, and a thickness.

Specific details and benefits of the determination system for the permeation rate provided by the present invention can refer to the above description of the determination method for the permeation rate, which will not be repeated here.

According to a seventh aspect of the present invention, provided is a computer-readable storage medium, having stored thereon a computer program which, when executed by a processor, implements a selection method for a target palladium membrane for a hydrogen-related reaction, a execution method for a hydrogen-related reaction and/or a determination method for a permeation rate.

Other features and advantages of the present invention will be described in detail in the subsequent Detailed Description.

## Brief Description of Drawings

The accompanying drawings are used to provide a further understanding of the embodiments of the present invention and constitute a part of the description, and are used to explain the embodiments of the present invention together with the following specific embodiments, but do not constitute limitations on the embodiments of the present invention. In the drawing:

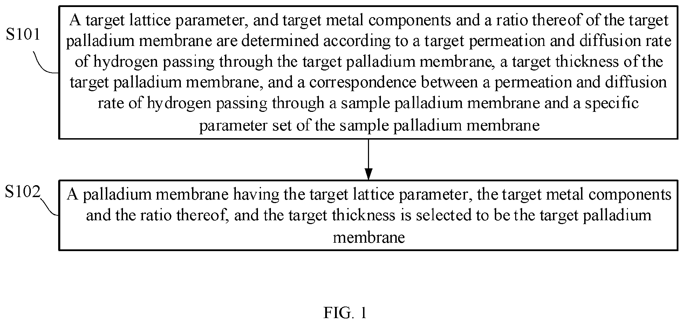

FIG. 1 is a flow chart of a selection method for a target palladium membrane according to an embodiment of the present invention.

**Detailed Description of the Embodiments**

The specific embodiments of the present invention will be described below in detail with reference to the accompanying drawings. It should be understood that the specific embodiments described herein are merely illustrative and explanatory of the present invention, and are not intended to limit the present invention.

FIG. 1 is a flow chart of a selection method for a target palladium membrane according to an embodiment of the present invention. As shown in FIG. 1, the selection method for the target palladium membrane may include: Step S101, a target lattice parameter, and target metal components and a ratio thereof of the target palladium membrane are determined according to a target permeation rate of hydrogen passing through the target palladium membrane, a target thickness of the target palladium membrane, and a correspondence between a permeation rate of hydrogen passing through a sample palladium membrane and a specific parameter set of the sample palladium membrane, wherein the specific parameter set includes a lattice parameter, a metal composition coefficient and a thickness; and Step S102, a palladium membrane having the target lattice parameter, the target metal components and the ratio thereof, and the target thickness is selected to be the target palladium membrane.

Before performing the step S101, the selection method for the target palladium membrane further includes the correspondence between the permeation rate of the hydrogen passing through the sample palladium membrane and the specific parameter set of the sample palladium membrane is obtained.

In an embodiment, the correspondence between the permeation rate of the hydrogen passing through the sample palladium membrane and the specific parameter set of the sample palladium membrane may be a one-to-one correspondence between a hydrogen permeation rate and a specific parameter set presented in a tabular form, as shown in Table 1.

Table 1

|  | Metal species in alloy | A/mol·s$^{-1}$ | Lattice parameter k | Thickness/$\mu$m | $J_{H2}$ |
|---|---|---|---|---|---|
| 1 | Pd and Cu | 0.963264 E-15 | 0.2768 | 6 | 0.58 |
| **2** | **Pd and Cu** | **0.968544 E-15** | **0.2832** | **6** | **0.57** |
| 3 | Pd and Cu | 0. 957696 E-15 | 0.2752 | 6 | 0.58 |
| 4 | Pd and Ag | 1.144688 E-15 | 0.4125 | 7.5 | 0.37 |
| 5 | Pd and Ag | 1.137521 E-15 | 0.4051 | 7.8 | 0.36 |
| 6 | Pd and Ag | 1.16088 E-15 | 0.4146 | 8 | 0.35 |
| 7 | Pd and Ag | 1.126488 E-15 | 0.4016 | 8.5 | 0.33 |
| 8 | Pd and Au | 0.99744 E-15 | 0.4156 | 10 | 0.24 |
| 9 | Pd and Au | 0.99912 E-15 | 0.4163 | 10 | 0.24 |
| 10 | Pd and Au | 0.99576 E-15 | 0.4149 | 10 | 0.24 |
| 11 | Pd and Au | 0.99072 E-15 | 0.4128 | 10 | 0.24 |
| 12 | Pd, Cu and Au | 0.8268 E-15 | 0.4134 | 8 | 0.25 |
| 13 | Pd, Cu and Au | 0.82566 E-15 | 0.417 | 9 | 0.22 |
| 14 | Pd, Cu and Au | 0.8196 E-15 | 0.4098 | 8 | 0.25 |
| 15 | Pd, Cu and Au | 0.822 E-15 | 0.411 | 8 | 0.25 |
| 16 | Pd, Cu and Au | 0.8244 E-15 | 0.4122 | 8 | 0.25 |
| 17 | Pd, Cu and Au | 0.8372 E-15 | 0.4186 | 8 | 0.25 |
| 18 | Pd, Cu and Ag | 1.30304 E-15 | 0.4072 | 10 | 0.32 |
| 19 | Pd, Cu and Ag | 1.291815 E-15 | 0.4101 | 9 | 0.35 |
| 20 | Pd, Cu and Ag | 1.288 E-15 | 0.4025 | 10 | 0.32 |
| 21 | Pd, Cu and Ag | 1.29332 E-15 | 0.4172 | 10 | 0.31 |
| 22 | Pd, Cu and Ag | 1.32608 E-15 | 0.4144 | 10 | 0.32 |
| 23 | Pd and Cu | 0.97104 E-15 | 0.289 | 6 | 0.56 |
| 24 | Pd and Cu | 0.930072 E-15 | 0.2981 | 6 | 0.52 |

(continued)

|  | Metal species in alloy | A/mol·s⁻¹ | Lattice parameter k | Thickness/μm | $J_{H2}$ |
|---|---|---|---|---|---|
| 25 | Pd and Cu | 0.95742 E-15 | 0.2955 | 6 | 0.54 |
| **26** | **Pd, Cu and Ni** | **0.928872 E-15** | **0.2716** | **6** | **0.57** |
| 27 | Pd, Cu and Ni | 1.16812 E-15 | 0.2755 | 8 | 0.53 |
| 28 | Pd, Cu and Ni | 1.062375 E-15 | 0.2833 | 7.5 | 0.50 |
| 29 | Pd, Cu and Ni | 1.16325 E-15 | 0.282 | 7.5 | 0.55 |

Note: **E-15 represents **×10⁻¹⁵.

After the correspondences shown in Table 1 are obtained, the hydrogen permeation rate required for the hydrogen-related reaction and the target thickness can be input into Table 1, and a combination of the lattice parameter and the metal composition coefficient can be obtained by searching. And the combination may be one or more. If there is one combination, target metal components and a ratio thereof can be obtained according to a target metal composition coefficient in combination with a correspondence between the metal composition coefficient and the metal components and the ratio thereof; and a palladium membrane having the target lattice parameter, the target metal components and the ratio thereof, and the target thickness is taken as a target palladium membrane. If there are a plurality of combinations, for each combination: target metal components and a ratio thereof can be obtained according to a target metal composition coefficient in combination with a correspondence between the metal composition coefficient and the metal components and the ratio thereof; and a palladium membrane having the target lattice parameter, the target metal components and the ratio thereof, and the target thickness can be taken as a target palladium membrane. That is, the target palladium membrane can be a plurality of target palladium membranes. When the target palladium membranes are actually applied to a hydrogen-related reaction, any one of the plurality of the target palladium membranes can be selected to participate in the hydrogen-related reaction; or, one of the target palladium membranes can be selected by taking into account other conditions (for details, see the relevant description of an execution method for a hydrogen-related reaction below).

In the case of a hydrogen permeation rate $J_{H2}$ of 0.57 and a thickness d of 6 μm, a plurality of possible combinations of lattice parameters k and metal composition coefficients A in Table 1 can be determined: for example (0.2832, 0.968544 E-15); or (0.2716, 0.928872 E-15). From the correspondence between A and metal components (a default ratio is 1:1 or 1:1:1) shown in Table 1, it can be determined that a target lattice constant k=0.2832 and target metal components (and a ratio thereof) are a palladium copper (PdCu) alloy (the ratio is 1:1); and a target lattice constant k=0.2716 and target metal components (and a ratio thereof) are a palladium copper nickel (PdCuNi) alloy (the ratio is 1:1:1). That is, a palladium copper (PdCu) alloy (the ratio is 1:1) palladium membrane with k=0.2832 and d=6 μm and a palladium copper nickel (PdCuNi) alloy (the ratio is 1:1:1) palladium membrane with k=0.2716 and d=6 μm are selected as target palladium membranes. Then, for the case where the hydrogen-related reaction is a reaction in which hydrogen, oxygen and propene are used as substrates to synthesize propylene oxide, a target lattice constant k=0.2832 and a palladium copper (PdCu) alloy (the ratio is 1:1) is selected as the target metal components (and a ratio thereof) considering that the palladium copper (PdCu) bialloy membrane has better sulfur resistance and carbon deposition resistance against propylene in the reaction system, and a trace amount of propane, sulfur-containing compounds and other impurities that may be present in propylene.

In another embodiment, the correspondence between the permeation rate of the hydrogen passing through the sample palladium membrane and the specific parameter set of the sample palladium membrane includes:

$$J_{H2} = \frac{A}{k \times d}, \quad \text{Equation 1}$$

wherein $J_{H2}$ is a permeation rate of hydrogen passing through the sample palladium membrane; k is a lattice parameter of the sample palladium membrane; d is a thickness of the sample palladium membrane; and A is a metal composition coefficient of the sample palladium membrane.

After the equation 1 is obtained, the target permeation rate required for the hydrogen-related reaction and the target thickness can be input into the equation 1, and a combination of the lattice parameter and the metal composition coefficient can be obtained. And the combination may be one or more. If there is one combination, target metal components and a ratio thereof can be obtained according to a target metal composition coefficient in combination with a correspondence between the metal composition coefficient and the metal components and the ratio thereof; and a palladium membrane having the target lattice parameter, the target metal components and the ratio thereof, and the target thickness is taken as a target palladium membrane. If there are a plurality of combinations, for each combination: target metal components and a ratio thereof can be obtained according to a target metal composition coefficient in combination with a correspondence between the metal composition coefficient and the metal components and the ratio thereof; and a palladium membrane having the target lattice parameter, the target metal components and the ratio thereof, and the target thickness can be taken as a target palladium membrane. That is, the target palladium membrane can be a plurality of target palladium membranes. When the target palladium membranes are actually applied to a hydrogen-related reaction, any one of the plurality of the target palladium membranes can be selected to participate in the hydrogen-related reaction; or, one of the target palladium membranes can be selected by taking into account other conditions (for details, see the relevant description of an execution method for a hydrogen-related reaction below).

In the case of a hydrogen permeation rate $J_{H2}$ of 0.57 and a thickness d of 6 $\mu$m, a plurality of possible combinations of lattice parameters k and metal composition coefficients A can be determined by the equation 1: for example (0.2832, 0.968544 E-15); or (0.2716, 0.928872 E-15). From the correspondence between A and metal components (a default ratio is 1:1 or 1:1:1) (as shown in Table 1), it can be determined that a target lattice constant k=0.2832 and target metal components (and a ratio thereof) are a palladium copper (PdCu) alloy (the ratio is 1:1); and a target lattice constant k=0.2716 and target metal components (and a ratio thereof) are a palladium copper nickel (PdCuNi) alloy (the ratio is 1:1:1). Then, for the case where the hydrogen-related reaction is a reaction in which hydrogen, oxygen and propene are used as substrates to synthesize propylene oxide, a target lattice constant k=0.2832 and a palladium copper (PdCu) alloy (the ratio is 1:1) is selected as the target metal components (and a ratio thereof) considering that the palladium copper (PdCu) bialloy membrane has better sulfur resistance and carbon deposition resistance against propylene in the reaction system, and a trace amount of propane, sulfur-containing compounds and other impurities that may be present in propylene.

In particular, A depends on the number of metal species of the sample palladium membrane, a relative atomic mass and a density of each metal, and an average relative atomic mass and an average density of the sample palladium membrane.

For example, A is determined by:

$$A = (n-1)! \times \frac{\left[\frac{M_a^n}{\Sigma_i^n M_i}\right]^{\frac{1}{n}} \times \left[\frac{\Sigma_i^n \rho_i}{\rho_a^n}\right]^{\frac{1}{n}}}{10^5}, \quad \text{Equation 2}$$

wherein n is the number of metal species of the sample palladium membrane, $M_i$ and $\rho_i$ are a relative atomic mass and a density of an ith metal of the sample palladium membrane, respectively, and $M_a$ and $\rho_a$ are an average relative atomic mass and an average density of the sample palladium membrane, respectively.

Of course, A is not limited to adopt the above equation 2, and may also adopt a reasonable variation of the above equation 2. For example, on the basis of the equation 2, a weight coefficient w is multiplied. In particular, w may be a value close to 1.

In the case where the target lattice parameter and the target metal composition coefficient are selected, the target metal components and the ratio thereof can be obtained by the equation 2.

In yet another embodiment, the above equation 1 can be further optimized to add a correction coefficient that is related to the metal components of the sample palladium membrane.

The correspondence between the permeation rate of the hydrogen passing through the sample palladium membrane and the specific parameter set of the sample palladium membrane includes:

$$J_{H2} = \frac{A}{b \times k \times d}, \quad \text{Equation 3}$$

wherein $J_{H2}$ is a permeation rate of hydrogen passing through the sample palladium membrane; k is a lattice parameter of the sample palladium membrane; d is a thickness of the sample palladium membrane; A is a metal composition coefficient of the sample palladium membrane; and b is a correction coefficient.

After the equation 3 is obtained, the target permeation rate required for the hydrogen-related reaction and the target thickness can be input into the equation 3, and a combination of the lattice parameter and the metal composition coefficient can be obtained. And the combination may be one or more. If there is one combination, target metal components and a ratio thereof can be obtained according to a target metal composition coefficient in combination with a correspondence between the metal composition coefficient and the metal components and the ratio thereof; and a palladium membrane having the target lattice parameter, the target metal components and the ratio thereof, and the target thickness is taken as a target palladium membrane. If there are a plurality of combinations, for each combination: target metal components and a ratio thereof can be obtained according to a target metal composition coefficient in combination with a correspondence between the metal composition coefficient and the metal components and the ratio thereof; and a palladium membrane having the target lattice parameter, the target metal components and the ratio thereof, and the target thickness can be taken as a target palladium membrane. That is, the target palladium membrane can be a plurality of target palladium membranes. When the target palladium membranes are actually applied to a hydrogen-related reaction, any one of the plurality of the target palladium membranes can be selected to participate in the hydrogen-related reaction; or, one of the target palladium membranes can be selected by taking into account other conditions (for details, see the relevant description of an execution method for a hydrogen-related reaction below).

In particular, A depends on the number of metal species of the sample palladium membrane, a relative atomic mass and a density of each metal, and an average relative atomic mass and an average density of the sample palladium membrane.

For example, A is determined by:

$$A = (n-1)! \times \left[\frac{M_a^n}{\sum_i^n M_i}\right]^{\frac{1}{n}} \times \left[\frac{\sum_i^n \rho_i}{\rho_a^n}\right]^{\frac{1}{n}} / 10^5 \quad \text{Equation 4}$$

wherein n is the number of metal species of the sample palladium membrane, $M_i$ and $\rho_i$ are a relative atomic mass and a density of an ith metal of the sample palladium membrane, respectively, and $M_a$ and $\rho_a$ are an average relative atomic mass and an average density of the sample palladium membrane, respectively.

Of course, A is not limited to adopt the above equation 4, and may also adopt a reasonable variation of the above equation 4. For example, on the basis of the equation 4, a weight coefficient w is multiplied. In particular, w may be a value close to 1.

In the case where the target lattice parameter and the target metal composition coefficient are selected, the target metal components and the ratio thereof can be obtained by the equation 4.

In particular, b depends on an effective atomic radius of the sample palladium membrane. b is in the range of 1-5.

Value ranges for b are described below for specific materials of the sample palladium membrane, respectively. In the present invention, the palladium membrane is a tubular or sheet metal palladium or palladium alloy membrane which is common in the art. Preferably, the palladium membrane contains Pd, a group IB metal element and optionally Ni. A molar ratio of the group IB metal element (or a group IB metal) to Pd may be 0.01-10, for example, 0.01, 0.05, 0.1, 0.2, 0.25, 0.3, 0.4, 0.5, 0.6, 0.7, 0.8, 0.9, 1, 1.1, 1.2, 1.3, 1.4, 1.5, 1.6, 3, 5, 8, 9, 10 or any value between the above values, preferably 0.1-1.6, more preferably 0.2-0.8.

In the present invention, the group IB metal element may be at least one of Cu, Ag and Au, and preferably, the group IB metal element is Cu and/or Ag.

According to a preferred embodiment of the present invention, the palladium membrane contains Ni and a molar ratio of Ni to Pd is 0.35-0.65, for example, 0.35, 0.4, 0.45, 0.5, 0.55, 0.58, 0.6, 0.62, 0.65 or any value between the above values.

In a case where a material of the sample palladium membrane is a PdCu alloy, b is in the range of 1.01-2.51; more preferably, b is in the range of 1.55-1.94.

In the case where the material of the sample palladium membrane is a PdAg alloy, b is in the range of 1.12-2.53; more preferably, b is in the range of 1.71-2.2.

In the case where the material of the sample palladium membrane is a PdAu alloy, b is in the range of 1.56-3.62; more preferably, b is in the range of 2.01-3.37.

In the case where the material of the sample palladium membrane is a PdCuAg alloy, b is in the range of 1.93-3.69; more preferably, b is in the range of 2.02-3.23.

In the case where the material of the sample palladium membrane is a PdCuAu alloy, b is in the range of 2.56-4.99; more preferably, b is in the range of 2.83-4.61.

In the case where the material of the sample palladium membrane is a PdCuNi alloy, b is in the range of 1.63-2.71; more preferably, b is in the range of 1.96-2.51.

In the present invention, d=0.5-30 $\mu$m (e.g., 0.5 $\mu$m, 1 $\mu$m, 1.5 $\mu$m, 2 $\mu$m, 2.5 $\mu$m, 3 $\mu$m, 4 $\mu$m, 5 $\mu$m, 6 $\mu$m, 6.5 $\mu$m, 7 $\mu$m, 7.5 $\mu$m, 8 $\mu$m, 8.5 $\mu$m, 9 $\mu$m, 10 $\mu$m, 15 $\mu$m, 20 $\mu$m, 25 $\mu$m, 30 $\mu$m and any values between the above values), more preferably 5-15 $\mu$m, further preferably 6-8 $\mu$m.

The inventors of the present invention unexpectedly found during research that there is a certain correlation between $J_{H2}$, n, $M_a$, $M_i$, $\rho_a$, $\rho_i$ and d, so experimental data is fitted to obtain a formula shown in an equation 5.

$$J_{H2} = \frac{(n-1)! \times \left(\dfrac{M_a{}^n}{\sum\limits_{i=1}^{n} M_i}\right)^{\frac{1}{n}} \times \left(\dfrac{\sum\limits_{i=1}^{n} \rho_i}{\rho_a{}^n}\right)^{\frac{1}{n}}}{b \times 10^5 \times k \times d} \quad\text{, Equation 5}$$

wherein $J_{H2}$ is in mol·m$^{-2}$·s$^{-1}$;

k is in nm;

n is the species number of metals contained in a palladium membrane;

$M_a$ is an average relative atomic mass of n metals in g/mol;

$M_i$ is a relative atomic mass of an ith metal in g/mol;

$\rho_a$ is an average density of the n metals in kg/m$^3$;

$\rho_i$ is a density of the ith metal in kg/m$^3$;

d is a thickness of the palladium membrane in m; and

b is a correction coefficient, and is in the range of 1-5.

It should be noted that if the units of the parameters described above are not specifically indicated in the present invention, they are defaulted to the corresponding units described above.

In the present invention, a test method for $J_{H2}$ (a hydrogen permeation rate, unit: mol·m$^{-2}$·s$^{-1}$) is to measure a volume (L) of hydrogen passing through a palladium-based composite membrane per minute at 20°C under a transmembrane pressure difference of 0.1 MPa, and then normalize to the hydrogen permeation amount (mol·m$^{-2}$·s$^{-1}$) according to a membrane area (m$^2$).

In the present invention, the "lattice parameter k" refers to a physical dimension of a unit cell in a lattice and represents a basic structural parameter of a crystalline substance. The lattice parameter k represents a side length of the unit cell, that is, a side length of each parallelepiped unit, and is directly related to a bonding energy between atoms. A unit cell in a three-dimensional space typically has three lattice parameters, which are represented by a, b and c, respectively. According to the morphological distribution of Bravais lattices, these three constants are all equal in a cubic crystal structure (body-centered cubic close packing and face-centered cubic close packing) of the present invention, and can therefore be represented by a parameter k. The change in k reflects the change in composition, stress state, etc. inside a crystal. The lattice parameter k can be determined by X-ray diffraction analysis (XRD) or atomic force microscopy analysis (AFM).

In the present invention, "body-centered cubic close packing" refers to a close-packing pattern in a cubic crystal system including two lattice points, one at a vertex and one at a body center, i.e., eight atoms at eight vertices of a cube and one atom at a center of the cube, each of the eight atoms at the vertices being tangent to the center atom.

In the present invention, "face-centered cubic closest packing" means that a unit cell involves 14 atoms belonging to 4 layers: a vertex angle is an A layer, 3 face-centered atoms and 3 vertex angle atoms nearest to the vertex angle belong to a B layer, the next 6 atoms belong to a C layer, and there is also a vertex angle which is opposite to the vertex angle of the A layer, and is in an A layer of a next cycle.

In the case of determining the hydrogen permeation rate required for the hydrogen-related reaction and the required thickness of the palladium membrane, the metal components and the ratio thereof, and the lattice constant of the palladium membrane can be selected by the above embodiments.

For example, if the hydrogen permeation rate J=0.35, and the thickness d=10 microns, suitable combinations of metal components and ratios thereof, and lattice constants can be determined by the equation 5, and can include: a palladium copper silver (PdCuAg) tri-alloy (a ratio of the alloy is 100:32.8:23.4), a correction coefficient b=3.15, and a lattice parameter k=0.4087; a palladium gold (PdAu) bialloy (a ratio of the alloy is 100:5.6), a correction coefficient b=3.03, and a lattice parameter k=0.3836; and a palladium silver (PdAg) bialloy (a ratio of the alloy is 100:58.7), a correction coefficient b=1.29, and a lattice parameter k=0.4034. All of the above three combinations of palladium membranes can be identified as target palladium membranes.

For example, if the hydrogen permeation rate J=0.26, and the thickness d=10 microns, suitable combinations of metal components and ratios thereof, and lattice constants can be determined by the equation 5, and can include: a palladium gold (PdAu) bialloy (a ratio of the alloy is 75:25), a correction coefficient b=2.01, and a lattice parameter k=0.4156; a palladium copper gold (PdCuAu) tri-alloy (a ratio of the alloy is 100:13.5:9.2), a correction coefficient b=3.86, and a lattice parameter k=0.4062; and a palladium copper silver (PdCuAg) tri-alloy (a ratio of the alloy is 100:19.7:23.5), a correction coefficient b=2.53, and a lattice parameter k=0.4284. All of the above three combinations of palladium membranes can be identified as target palladium membranes.

For example, if the hydrogen permeation rate J=0.36, and the thickness d=7.5 microns, suitable combinations of metal components and ratios thereof, and lattice constants can be determined by the equation 5, and can include: a palladium silver (PdAg) bialloy (a ratio of the alloy is 100:54), a correction coefficient b=1.75, and a lattice parameter k=0.4125; a palladium gold (PdAu) bialloy (a ratio of the alloy is 100:8.8), a correction coefficient b=3.36, and a lattice parameter k=0.3863; and a palladium copper silver (PdCuAg) tri-alloy (a ratio of the alloy is 100:15.3:26.6), a correction coefficient b=2.80, and a lattice parameter k=0.3953. All of the above three combinations of palladium membranes can be identified as target palladium membranes. For example, if the hydrogen permeation rate J=0.58, and the thickness d=6 microns, suitable combinations of metal components and ratios thereof, and lattice constants can be determined by the equation 5, and can include: a palladium copper (PdCu) bialloy (a ratio of the alloy is 100:113), a correction coefficient b=1.89, and a lattice parameter k=0.2768; a palladium copper nickel (PdCuNi) tri-alloy (a ratio of the alloy is 100:34.5:29.1), a correction coefficient b=2.22, and a lattice parameter k=0.2716; and a palladium silver (PdAg) bialloy (a ratio of the alloy is 100:153), a correction coefficient b=1.23, and a lattice parameter k=0.3319. All of the above three combinations of palladium membranes can be identified as target palladium membranes.

In summary, the present invention inventively first determines the target lattice parameter, and the target metal components and the ratio thereof of the target palladium membrane according to the target permeation rate of the hydrogen passing through the target palladium membrane, the target thickness of the target palladium membrane, and the correspondence between the permeation rate of the hydrogen passing through the sample palladium membrane and the specific parameter set of the sample palladium membrane; and then selects the palladium membrane having the target lattice parameter, the target metal components and the ratio thereof, and the target thickness to be the target palladium membrane. In the present invention, an appropriate palladium membrane can be efficiently and conveniently selected to satisfy a target hydrogen permeation rate of a hydrogen-related reaction.

An embodiment of the present invention provides an execution method for a hydrogen-related reaction, including: one or more target palladium membranes are selected according to a selection method for a target palladium membrane, wherein a permeation rate of hydrogen passing through any one of the one or more target palladium membranes is a target permeation rate; and the hydrogen-related reaction is executed with one of the one or more target palladium membranes.

A process for selecting the target palladium membrane for the hydrogen-related reaction can refer to the above relevant description of the selection method for the target palladium membrane, which will not be repeated here.

Wherein the hydrogen-related reaction is a reaction in which hydrogen, oxygen and propene are used as substrates to synthesize propylene oxide.

Wherein the hydrogen-related reaction is a reaction in which hydrogen and oxygen are used as substrates to synthesize hydrogen peroxide.

Wherein the hydrogen-related reaction is a reaction for hydrogen production by steam reforming of alcohol and water.

Wherein the hydrogen-related reaction is a carbon dioxide hydrogenation reaction.

Wherein the hydrogen-related reaction is a reaction in which hydrogen and nitrogen are used as substrates to synthesize ammonia gas.

Wherein the hydrogen-related reaction is a reaction in which ethane is dehydrogenated to prepare ethylene.

Wherein the hydrogen-related reaction is a reaction in which propane is dehydrogenated to prepare propylene.

Wherein the hydrogen-related reaction is a reaction in which butane is dehydrogenated to form butadiene.

Wherein the hydrogen-related reaction is a reaction in which isopentene is dehydrogenated to form isoprene;

wherein the hydrogen-related reaction is a reaction in which ethylbenzene is dehydrogenated to prepare styrene;
wherein the hydrogen-related reaction is a reaction in which isobutane is dehydrogenated to prepare isobutylene;
wherein the hydrogen-related reaction is a reaction in which benzene is hydrogenated to prepare cyclohexane;
wherein the hydrogen-related reaction is a reaction in which benzene, hydrogen, and oxygen are used as substrates to prepare phenol;
wherein the hydrogen-related reaction is a reaction in which carbon monoxide is hydrogenated to prepare methanol;
wherein the hydrogen-related reaction is a reaction in which phenol is hydrogenated to prepare cyclohexanol;
wherein the hydrogen-related reaction is a reaction in which nitrobenzene is subjected to hydrogenation reduction to prepare aniline; or
Wherein the hydrogen-related reaction is a reaction in which butane is dehydrogenated to form butadiene.

In the case of determining the hydrogen permeation rate required for the hydrogen-related reaction and the required thickness of the palladium membrane, the metal components and the ratio thereof, and the lattice constant of the palladium membrane can be selected by the above embodiments. Several specific hydrogen-related reactions will be described below as examples.

For example, in the case where the hydrogen-related reaction is a carbon dioxide hydrogenation reaction, if the hydrogen permeation rate J=0.35, and the thickness d=10 microns, suitable combinations of metal components and ratios thereof, and lattice constants can be determined by the equation 5, and can include: a palladium copper silver (PdCuAg) tri-alloy (a ratio of the alloy is 100:32.8:23.4), the correction coefficient b=3.15, and the lattice parameter k=0.4087; a palladium gold (PdAu) bialloy (a ratio of the alloy is 100:5.6), the correction coefficient b=3.03, and the lattice parameter k=0.3836; and a palladium silver (PdAg) bialloy (a ratio of the alloy is 100:58.7), the correction coefficient b=1.29, and the lattice parameter k=0.4034. Considering that compared with the palladium gold (PdAu) and palladium silver (PdAg) bialloys, the palladium copper silver (PdCuAg) tri-alloy membrane has a better activation effect on carbon dioxide, the hydrogenation of carbon dioxide to produce gasoline fraction hydrocarbons can be effectively promoted, and meanwhile, compared with the palladium gold and palladium silver bialloys, the palladium copper silver tri-alloy membrane can better tolerate the toxic effect of gasoline fraction hydrocarbons on a palladium-based composite membrane body and has a better service life. In summary, the palladium copper silver (PdCuAg) tri-alloy membrane is more suitable for use in a process for the hydrogenation of carbon dioxide to produce gasoline fraction hydrocarbons. Therefore, the palladium copper silver (PdCuAg) tri-alloy (the ratio of the alloy is 100:32.8:23.4), the correction coefficient b=3.15, and the lattice parameter k=0.4087 are used.

For example, in the case where the hydrogen-related reaction is a reaction for hydrogen production by steam reforming of methanol and water, if the hydrogen permeation rate J=0.26, and the thickness d=10 microns, suitable combinations of metal components and ratios thereof, and lattice constants can be determined by the equation 5, and can include: a palladium gold (PdAu) bialloy (a ratio of the alloy is 75:25), the correction coefficient b=2.01, and the lattice parameter k=0.4156; a palladium copper gold (PdCuAu) tri-alloy (a ratio of the alloy is 100:13.5:9.2), the correction coefficient b=3.86, and the lattice parameter k=0.4062; and a palladium copper silver (PdCuAg) tri-alloy (a ratio of the alloy is 100:19.7:23.5), the correction coefficient b=2.53, and the lattice parameter k=0.4284. Considering that the carbon deposition resistance of the palladium gold (PdAu) bialloy membrane is more prominent, compared with the palladium copper gold (PdCuAu) and palladium copper silver (PdCuAg) tri-alloy membranes, the toxicity of small molecule carbon-containing organic compounds such as CO and methanol and water vapor to the palladium gold bialloy membrane is weaker, and the palladium gold (PdAu) bialloy membrane can efficiently activate reactants such as methanol and water vapor, and has a better catalytic effect on the reaction. In summary, the palladium gold (PdAu) bialloy membrane is more suitable for use in a process for hydrogen production by steam reforming of alcohols and water. Therefore, the palladium gold (PdAu) bialloy (the ratio of the alloy is 75:25), the correction coefficient b=2.01, and the lattice parameter k=0.4156 are used.

For example, in the case where the hydrogen-related reaction is a reaction in which hydrogen and oxygen are used as substrates to synthesize hydrogen peroxide, if the hydrogen permeation rate J=0.36, and the thickness d=7.5 microns, suitable combinations of metal components and ratios thereof, and lattice constants can be determined by the equation 5, and can include: a palladium silver (PdAg) bialloy (a ratio of the alloy is 100:54), the correction coefficient b=1.75, and the lattice parameter k=0.4125; a palladium gold (PdAu) bialloy (a ratio of the alloy is 100:8.8), the correction coefficient b=3.36, and the lattice parameter k=0.3863; and a palladium copper silver (PdCuAg) tri-alloy (a ratio of the alloy is 100:15.3:26.6), the correction coefficient b=2.80, and the lattice parameter k=0.3953. Considering that the palladium silver (PdAg) bialloy membrane can achieve activation of the $H_2$ molecule and the $O_2$ molecule simultaneously, promoting generation of HOO* and H* radicals, and the synergistic catalytic effect on the direct synthesis of hydrogen peroxide from hydrogen and oxygen is better; and at the same time, the direct synthesis of hydrogen peroxide from hydrogen and oxygen is a fast reaction, and compared with the palladium gold (PdAu) bialloy and the palladium copper silver (PdCuAg) tri-alloy, the palladium silver (PdAg) bialloy membrane can provide more free radicals, which is helpful to improve the catalytic reaction rate. In summary, the palladium silver (PdAg) bialloy membrane is more suitable for use in a reaction process for the direct synthesis of hydrogen peroxide from hydrogen and oxygen. Therefore, the palladium silver (PdAg) bialloy (the ratio of the alloy is 100:54), the correction coefficient b=1.75, and the lattice parameter k=0.4125 are used.

For example, in the case where the hydrogen-related reaction is a reaction in which hydrogen, oxygen and propene are used as substrates to synthesize propylene oxide, if the hydrogen permeation rate J=0.58, and the thickness d=6 microns, suitable combinations of metal components and ratios thereof, and lattice constants can be determined by the equation 5, and can include: a palladium copper (PdCu) bialloy (a ratio of the alloy is 100:113), the correction coefficient b=1.89, and the lattice parameter k=0.2768; a palladium copper nickel (PdCuNi) tri-alloy (a ratio of the alloy is 100:34.5:29.1), the correction coefficient b=2.22, and the lattice parameter k=0.2716; and a palladium silver (PdAg) bialloy (a ratio of the alloy is 100:153), the correction coefficient b=1.23, and the lattice parameter k=0.3319. Considering that the temperature of direct epoxidation of propene in a gas phase is relatively low (less than 200°C), coexisting phases of α-PdH and β-PdH exist in the palladium copper nickel (PdCuNi) tri-alloy membrane after hydrogen dissolution in this temperature interval, and the mismatch of unit cell structures between the two phases is prone to hydrogen embrittlement fracture. The palladium copper bialloy membrane with a body-centered cubic structure (BCC-PdCu) has no coexistence of two crystalline phases under the same operating conditions, reducing the risk of hydrogen embrittlement. Compared with the palladium silver (PdAg) bialloy membrane, the palladium copper (PdCu) bialloy membrane has better sulfur resistance and carbon deposition resistance against propylene in the reaction system, and a trace amount of propane, sulfur-containing compounds and other impurities that may be present in propylene. In summary, the palladium copper (PdCu) bialloy membrane is more suitable for use in a process for direct epoxidation of propene in the gas phase. Therefore, the palladium copper (PdCu) bialloy (the ratio of the alloy is 100:113), the correction coefficient b=1.89, and the lattice parameter k=0.2768 are used.

In an embodiment, the target palladium membrane is prepared by: (1) performing alloying treatment on a palladium membrane raw material under different conditions of the alloying treatment, measuring a lattice parameter of a product, and establishing a fitting curve of a correspondence between conditions of the alloying treatment and the lattice parameter; (2) determining a target condition of the alloying treatment according to a lattice parameter of the target palladium membrane and the fitting curve; and (3) performing alloying treatment on the palladium membrane raw material by using the target condition to obtain the target palladium membrane.

According to a preferred embodiment of the present invention, a database of the conditions of the alloying treatment and the lattice parameters is established based on a large number of experiments in the step (1), so that the conditions of the alloying treatment corresponding to the lattice parameter can be found more quickly and conveniently.

According to some embodiments of the present invention, the palladium membrane is a membranous material, in order to further ensure the operability of the material, the palladium membrane raw material may include a support body supporting the palladium membrane, and therefore, in the step (1), the palladium membrane raw material includes the support body and Pd and optionally other active components deposited on (one or both side surfaces) of the support body.

According to some embodiments of the present invention, a molar ratio of Pd to the other active components in the palladium membrane raw material is 1:(0.05-20), more preferably 1:(0.1-5), further preferably 1:(0.1-2).

According to some embodiments of the present invention, the other active components are selected from at least one of group IIIA, group VIII, group IB and group IIIB elements, more preferably group IB and/or group VIII elements, further preferably at least one of Cu, Ag, Au and Ni.

According to some embodiments of the present invention, metal elements in the palladium membrane include Pd and Cu, or Pd and Ag, or Pd and Au, or Pd, Cu and Au, or Pd, Cu and Ag, or Pd, Cu and Ni.

According to a preferred embodiment of the present invention, the palladium membrane raw material in the step (1) and the step (3) has the same composition.

According to some embodiments of the present invention, the support body has a thickness of 0.1-20 mm (e.g., 0.1 mm, 1 mm, 2 mm, 3 mm, 4 mm, 5 mm, 6 mm, 7 mm, 8 mm, 9 mm, 10 mm, 15 mm, 20 mm, and a range composed of any two values described above), preferably 2-5 mm. The support body may be provided by a material common in the art that can withstand the operating temperature of the present invention without affecting the hydrogen permeation performance, that is, without deforming at the operating temperature of the present invention and without affecting the hydrogen permeation performance. On the basis of ensuring excellent hydrogen permeation performance, in order to obtain more excellent mechanical stability and thermal stability and reduce the amount of palladium used (reduce the cost), preferably, the support body is a porous support body and may be selected from at least one of porous ceramic, porous glass, porous metal (e.g., porous stainless steel), porous quartz and a high-molecular polymer, more preferably at least one of the porous ceramic, the porous metal and the high-molecular polymer. Typically, the support body has a porosity distribution range of 15-75% and an average pore size of 0.05-0.4 $\mu$m. In order to obtain a tubular membrane, the support body is preferably a tubular support body. A material of the porous ceramic may be $\gamma$-Al$_2$O$_3$, and the porous ceramic may have a porosity distribution range of 25-66%, and an average pore size of 0.12-0.4 $\mu$m. A material of the porous stainless steel may be 316L (Fe$_{69}$Cr$_{17}$Ni$_{12}$Mo$_2$), and the porous stainless steel may have a porosity distribution range of 32-71%, and an average pore size of 0.08-0.36 $\mu$m. A material of the high-molecular polymer may be polyimide, and the high-molecular polymer may have a porosity distribution range of 15-37% and an average pore size of 0.05-0.22 $\mu$m. The "porosity distribution range" can be measured by nitrogen physisorption. The "average pore size" can be measured by nitrogen physisorption.

According to the present invention, the palladium membrane raw material is preferably prepared by depositing Pd and the other active components on a support body.

There are no special requirements for a manner of deposition, and according to some embodiments of the present invention, the manner of deposition is at least one of a vapor deposition method (such as physical vapor deposition or chemical vapor deposition), an electroless plating method, an electroplating method and an electroforming method, preferably at least one of the electroplating method and the electroless plating method. For example, the specific operation mode and conditions of the electroplating method are as follows: at a temperature of 10-50°C, with a conductive layer support as a working electrode, a platinum electrode (plated with Pd, Au or Ni), a silver electrode (plated with Ag) and a waveguide (plated with Cu) having a copper content of 99.999% as counter electrodes, and a saturated calomel electrode as a reference electrode, the concentration of metal ions (Pd$^{2+}$, and metal ions of other active components, such as Cu$^{2+}$, Au$^{3+}$, Ag$^+$, and Ni$^{2+}$) in a plating solution being 0.01-0.2 mol/L at a temperature of 30°C, a plating experiment is conducted by cyclic voltammetry, wherein an operating voltage interval is -0.60 V to -0.90 V; a scan rate is 0.01 V/s-0.0075 V/s; sweep segments are 200-2000; and the sensitivity is 0.001 A/V-0.0001 A/V. The corresponding metal ions in the plating solution are reduced and precipitated on the working electrode to form a dense metal membrane material (i.e., the palladium membrane raw material).

In the present invention, by comprehensively considering the hydrogen permeation rate, selectivity and cost, there are certain requirements for the palladium membrane. For example, a total thickness of Pd and other active components deposited on the support body in the palladium membrane raw material is 0.5-30 $\mu$m (e.g., 0.5 $\mu$m, 1 $\mu$m, 2 $\mu$m, 3 $\mu$m, 4 $\mu$m, 5 $\mu$m, 6 $\mu$m, 7 $\mu$m, 8 $\mu$m, 9 $\mu$m, 10 $\mu$m, 15 $\mu$m, 20 $\mu$m, 25 $\mu$m, 30 $\mu$m, and a range composed of any two values described above), preferably 5-15 $\mu$m.

According to some embodiments of the present invention, in the step (1), the conditions of the alloying treatment include: a temperature, a pressure, a time, a temperature reduction rate, and the like.

According to the present invention, preferably, a manner of the alloying treatment is as follows: the temperature is reduced to 100-250°C at a rate of more than 5°C/min, in particular 10-200°C/min after the palladium membrane raw material is treated at 300-800°C under 0.1-1 MPa for 1-10 h. More preferably, the manner of the alloying treatment is as follows: the temperature is reduced to 120-230°C at a rate of 20-150°C/min after the palladium membrane raw material is treated at 350-650°C under 0.12-0.8 MPa for 2-8 h. Performing the alloying treatment in the above manner can further improve the crystal stability of the palladium membrane, thereby further improving the hydrogen permeation stability thereof (the time from the start of fluctuation to the final stability of the hydrogen permeation amount is further shortened). In the above preferred alloying treatment manner, there is no special requirement for a heating rate of the palladium membrane raw material.

According to the present invention, in order to obtain a material to be used, a step of natural cooling to room temperature may also be included after the alloying treatment.

According to the present invention, the alloying treatment is preferably carried out under an activating atmosphere. Gas providing the activating atmosphere may be any gas common in the art which is gaseous under alloying conditions, but preferably the activating atmosphere is provided by at least one of a noble gas (such as Ar), $N_2$, water vapor, $H_2$, an acidic gas (such as $CO_2$), and a basic gas (which may be an organic basic gas or an inorganic basic gas, such as ethylenediamine and $NH_3$). Wherein the addition of the basic gas enables faster activation of the palladium-based alloy membrane and a more stable body-centered (or face-centered) cubic structure to be formed, and therefore, more preferably, the activating atmosphere is provided by a non-basic gas and a basic gas.

According to some embodiments of the present invention, the gas providing the activating atmosphere includes $H_2$, $N_2$ and $NH_3$, and a volume ratio of $H_2$ to $N_2$ to $NH_3$ is 1:(0.1-2.5):(0.01-0.5); further preferably 1:(0.2-0.8):(0.01-0.3).

According to some embodiments of the present invention, the gas providing the activating atmosphere includes $H_2$ and $N_2$, and a volume ratio of $H_2$ to $N_2$ is 1:(0.1-4), further preferably 1:(0.2-3.4).

According to some embodiments of the present invention, the gas providing the activating atmosphere includes $H_2$ and Ar, and a volume ratio of $H_2$ to Ar is 1:(0.1-8), further preferably 1:(0.5-6).

In order to verify the accuracy of the fitting curve of the correspondence between the conditions of the alloying treatment and the lattice parameter in the step (1), the step (1) may further include: testing a hydrogen permeation activation energy of a product, and establishing a fitting curve of a correspondence between the conditions of the alloying treatment and the hydrogen permeation activation energy.

In the present invention, preferably, the hydrogen permeation activation energy is measured by a palladium membrane hydrogen permeation system.

According to the present invention, in order to further improve the sulfur resistance, chlorine resistance, and carbon deposition resistance of a composite palladium-based alloy material, the composite palladium-based alloy material may also be covered with a protective layer which does not affect the hydrogen permeation performance (the hydrogen permeation activation energy) of the composite palladium-based alloy material, and a protective layer common in the art may be used, for example, a modified molecular sieve or an unmodified molecular sieve; wherein the molecular sieve may be a titanium silicalite molecular sieve or a silica-alumina molecular sieve; and the modified molecular sieve can be a noble metal (e.g., Au) doped molecular sieve, a silanized molecular sieve, a molecular sieve modified with an active component layer (e.g., a $MoO_2$ nanoparticle layer and a $Na-Fe_3O_4$ nanoparticle layer), or the like. Accordingly, the present invention also provides a composite membrane including a composite palladium-based alloy material and a protective layer covering a surface of the composite palladium-based alloy material. Accordingly, a method for preparing the composite membrane may include: preparing a composite palladium-based alloy material according to the method described above, followed by covering a surface of the composite palladium-based alloy material with a protective layer. A method of covering the protective layer may be an in situ generation method. The pore size distribution of the protective layer may be in 0.5-50 nm.

The present invention also provides a method for preparing a palladium membrane, including depositing Pd and Cu on a support body, and performing alloying treatment on the support body on which Pd and Cu are deposited, wherein a molar ratio of Pd to Cu is 100:(90-120).

According to the method for preparing the palladium membrane provided by the present invention, preferably, a manner of the alloying treatment is as follows: after treatment at a temperature of 570-600°C under a pressure of 0.37-0.52 MPa for 4-7 h in an activating atmosphere, the temperature is reduced to 120-180°C at a rate of 55-85°C/min (55°C/min, 60°C/min, 65°C/min, 70°C/min, 75°C/min, 80°C/min, 85°C/min, and a range composed of any two values described above), wherein gas providing the activating atmosphere includes $H_2$, $N_2$ and $NH_3$, and a volume ratio of $H_2$ to $N_2$ to $NH_3$=100:(27-77):(1-21). A palladium membrane prepared by this method has a high hydrogen permeation rate. A palladium-copper alloy material obtained according to this preferred embodiment has higher hydrogen permeability or stability. The addition of the basic gas $NH_3$ enables faster activation of the palladium-based alloy membrane, a more stable body-centered cubic structure to be formed and a half-peak width of characteristic peaks in an XRD pattern to be smaller.

In the present invention, the pressure of the alloying treatment is generally controlled by regulating the usage amount of gas providing the activating atmosphere. After the temperature is reduced to 180°C at a specified rate, cooling can be performed at an ambient temperature to room temperature for standby application.

According to the method for preparing the palladium membrane provided by the present invention, preferably, Pd and Cu deposited on the support body have a total thickness of 0.5-30 $\mu$m (e.g., 0.5 $\mu$m, 1 $\mu$m, 1.5 $\mu$m, 2 $\mu$m, 2.5 $\mu$m, 3 $\mu$m, 4 $\mu$m, 5 $\mu$m, 6 $\mu$m, 6.5 $\mu$m, 7 $\mu$m, 7.5 $\mu$m, 8 $\mu$m, 8.5 $\mu$m, 9 $\mu$m, 10 $\mu$m, 15 $\mu$m, 20 $\mu$m, 25 $\mu$m, 30 $\mu$m, and a range composed of any two values described above), more preferably 5-15 $\mu$m, further preferably 6-8 $\mu$m.

According to the method for preparing the palladium membrane provided by the present invention, preferably, the support body has a thickness of 0.1-20 mm (e.g., 0.1 mm, 1 mm, 2 mm, 3 mm, 4 mm, 5 mm, 6 mm, 7 mm, 8 mm, 9 mm, 10 mm, 15 mm, 20 mm, and a range composed of any two values described above), preferably 2-5 mm.

Hereinafter, the present invention will be described in detail by way of embodiments. In the following embodiments, an inner surface of the support body is sealed by a polytetrafluoroethylene material, so the polytetrafluoroethylene material is peeled off before application or performance testing.

Embodiments

(I) Preparation of a palladium-based alloy material

A porous stainless steel tube was used as a support body (tubular, an inner diameter: 9.5-10.5 mm, an outer diameter: 12.5-13.5 mm; an average pore size: 0.25 $\mu$m, and a porosity: 65%), the support body was first soaked with absolute ethanol for 30 minutes in order to remove contaminants such as dust, grease and the like from the surface, then the surface and inside of the support body were rinsed with deionized water, and the rinsed support body was placed in warm water, and washed by pumping using a vacuum pump to thoroughly remove residual ethanol in pores, and finally the washed support body was placed in an oven to be dried at 423 K for 4 h; and Pd and other active components (at least one of Cu, Ag, Au and Ni) were deposited on the support body by using an electroplating method according to the Faraday's law, wherein the kinds and molar ratios of Pd and other active components are shown in Table 2, and an effective membrane area was 21-50 cm$^2$; wherein the conditions of electroplating were as follows: with a conductive layer support as a working electrode, a platinum electrode (plated with Pd) and the other active component electrode (plated with other active components) as counter electrodes, and a saturated calomel electrode as a reference electrode, the concentration of metal ions ($Pd^{2+}$, and metal ions of other active components, such as $Cu^{2+}$, $Au^{3+}$, $Ag^+$, and $Ni^{2+}$) in a plating solution being 0.01-0.3 mol/L at a temperature of 30°C, a plating experiment was conducted by cyclic voltammetry, wherein an operating voltage interval was -0.60 V to -0.90 V, a scan rate was 0.0075 V/s; sweep segments were 1000; and the sensitivity was set to be 0.0001 A/V. At the same time, during the plating process, a 0.05 mol/L solution of palladium(II)-ammonium chloride (($NH_4$)$_2$PdCl$_4$) was added at a rate of 1-2 ml/min, a salt solution of other active components at a certain concentration was added at a rate of 0.2-1.5 ml/min, ethylenediamine (EDA, 99%, analytically pure) was added at a rate of 0.05-0.12 ml/min, disodium ethylenediaminetetraacetate (EDTA-2Na, 99%, analytically pure) was added at a rate of 0.025-0.05 ml/min, and bipyridyl ($C_{10}H_8N_2$, 99%, analytically pure) was added at a rate of 0.01-0.015 ml/min into the plating solution with a plunger type constant flow pump. The above solutions were added while keeping the plating solution vigorously stirred (1000 r/min). After every 30 min of electroplating, the working electrode washed to be clean with distilled water was soaked in a 0.05 mol/L phosphoric acid ($H_3PO_4$) solution and a 0.05 mol/L dipotassium hydrogen phosphate ($K_2HPO_4$) solution for 10 min, respectively. The working electrode was treated in distilled water at 80-100°C for 10-15 min, and then taken out after the cyclic voltammetry procedure. The support body on which Pd and other active components were deposited was subjected to high-temperature alloying treatment, and a manner of the alloying treatment was as follows: the temperature was reduced to a temperature T2 at a rate V after treatment for a period of time (t) at a temperature T1 under a pressure P in an activating atmosphere, the types and volume ratios of gas providing the activating atmosphere are shown in Table 2, the gas providing the activating atmosphere was used in such an amount that the pressure of the alloying treatment was P, and the parameters are detailed in Table 2. The preparation conditions were changed to obtain a plurality of different palladium-based alloy materials (see Table 2 for details).

(II) The materials obtained after the alloying treatment in the embodiments and Comparative examples were characterized, a characterization method was as follows, and the crystal structure parameters of the obtained materials are shown in Tables 2-3.

The analysis of the crystal phase structures of the materials obtained after the alloying treatment was carried out on an X'Pert PRO/PANalytical type automatic X-ray diffractometer manufactured by Philips, Netherlands under experimental conditions of using a Cu $K_\alpha$ ray ($\lambda$=0.1543 nm), a tube pressure of 40 kV, a current of 40 mA, and a diffraction angle $2\theta$ scan in the range of 10-90°. An interplanar spacing of a sample was calculated by using a Bragg equation:

$$d=\lambda/2\ \sin\theta$$

wherein $\lambda$ is a wavelength corresponding to the Cu $K_\alpha$ ray and $\theta$ is an angle of a diffraction peak.

The crystal structure of the material obtained after the alloying treatment was tested at an European Synchrotron Radiation Center in France (a beam BM25A), which has a higher resolution, a synchrotron ray has a wavelength $\lambda$=0.0618886 nm or 0.077449 nm, a tube pressure was 10.0335 keV, a sample of 10×1 mm$^2$ was first taken to be placed in a quartz capillary having a diameter of 2 mm, two sections were sealed with quartz wool, and the quartz capillary was mounted on a rotatable sample stage (to ensure a uniform temperature and a larger radiation area), a test temperature being in the range of 298-473 K (heat supplied by a hot air blower), a pressure being in the range of 10$^{-4}$-130 kPa, and a test atmosphere being of first introducing hydrogen gas, performing vacuuming after treatment for 30 min, and then introducing helium gas as a protective gas for measurement.

A test method for a lattice parameter of the material obtained after alloying treatment was as follows: in conjunction with the in situ XRD test described above, unit cell parameters (collectively represented by three cell constants of a, b and c and three intersection angles $\alpha$, $\beta$ and $\gamma$ between edges of a unit cell) of the material obtained after the alloying treatment were obtained, interplanar spacings ($d_1$ $d_2$ $d_3$) of the corresponding characteristic crystal planes were obtained by conversion according to formulas d1=a/($\alpha^2+\beta^2+\gamma^2$)$^{0.5}$, d2=b/($\alpha^2+\beta^2+\gamma^2$)$^{0.5}$, and d3=c/($\alpha^2+\beta^2+\gamma^2$)$^{0.5}$, for example, the PdCu alloy material obtained in the present invention belongs to a body-centered cubic (BCC) packing structure, and its characteristic crystal planes included (110), (111), (200), (210), and (211); at the same time, from the X-ray diffraction results, a series of different characteristic crystal plane ratios (measured intensities corresponding to different crystal planes) can be obtained, for example, the plane (110) of the PdCu alloy material obtained in the present invention corresponded to a characteristic peak at $2\theta$=43°±1°, the plane (111) of the PdCu alloy material obtained in the present invention corresponded to a characteristic peak at $2\theta$=53°±1°, the plane (200) of the PdCu alloy material obtained in the present invention corresponded to a characteristic peak at $2\theta$=62°±1°, the plane (210) of the PdCu alloy material obtained in the present invention corresponded to a characteristic peak at $2\theta$=70°±1°, and the plane (211) of the PdCu alloy material obtained in the present invention corresponded to a characteristic peak at $2\theta$=79°±1°. The lattice parameter k of the corresponding material was obtained through conversion by HighScorePlus analysis software, combined with the peak intensities of the above characteristic crystal planes;

the thickness of the material obtained after the alloying treatment was measured by the result of a scanning electron microscope (model: JSM-7610F), and the thickness of the alloy membrane was determined by measuring according to a scale corresponding to a magnification; and

The half-peak width of the material obtained after the alloying treatment was measured by obtaining a radian value of the half-peak width from the XRD pattern test results in combination with the HighScore Plus software analysis.

A test method for $J_{H2}$ (a hydrogen permeation rate, a measured value, unit: mol·m$^{-2}$·s$^{-1}$) was to measure a volume (L) of hydrogen passing through a palladium-based composite membrane per minute at 20°C under a transmembrane pressure difference of 0.1 MPa, and then normalize to the hydrogen permeation amount (mol·m$^{-2}$·s$^{-1}$) according to a membrane area (m$^2$).

Table 2

| Parameter | | F1 | F2 | F3 | FD1 | FD2 | FD3 | FD4 | FD5 | FD6 | FD7 | FD8 | FD 9 |
|---|---|---|---|---|---|---|---|---|---|---|---|---|---|
| T1/°C | | 570 | 580 | 600 | -- | -- | -- | -- | -- | 700 | -- | -- | -- |
| PIMP a | | 0.52 | 0.4 | 0.37 | -- | -- | -- | -- | -- | -- | 0.1 | -- | -- |
| Species of gas of activating atmosphere | | $H_2:N_2:NH_3$ | $H_2:N_2:NH_3$ | $H_2:N_2:NH_3$ | $N_2$ | $H_2$ | Ar | $H_2:C O_2$ | -- | -- | -- | -- | -- |
| Volume ratio of gas of activating atmosphere | | 100:2 7:1.28 | 100:4 0:5 | 100:5 0:10 | -- | -- | -- | 1:1 | -- | -- | -- | -- | -- |
| t/h | | 4 | 5 | 4 | -- | -- | -- | -- | -- | -- | -- | -- | -- |
| V/(°C/min) | | 60 | 65 | 70 | -- | -- | -- | -- | 5 | -- | -- | -- | -- |
| T2/°C | | 120 | 160 | 140 | -- | -- | -- | -- | -- | -- | -- | -- | -- |
| Molar ratio of metals in alloy | | 100:1 10 | 100:9 0 | 100:1 20 | -- | -- | -- | -- | -- | -- | -- | 100: 1000 | 10 0:1 |
| Crystal structure | | BCC | BCC | BCC | BCC +FC C | BCC +FC C | BCC +FC C | BCC +FC C | BCC +FC C | BCC +FC C | BCC +FC C | FCC | FC C |
| Half-peak width corresponding to a characteristic crystal plane | (1 10 ) | 0.023 8 | 0.031 6 | 0.038 8 | 0.058 2 | 0.052 6 | 0.060 3 | 0.045 3 | 0.078 9 | 0.066 6 | 0.071 3 | 0.09 01 | 0.0 85 2 |
| | (1 11) | 0.037 8 | 0.041 3 | 0.046 1 | 0.064 9 | 0.060 5 | 0.071 1 | 0.055 9 | 0.086 9 | 0.074 7 | 0.080 6 | 0.10 03 | 0.0 92 8 |
| | (2 00 ) | 0.053 6 | 0.059 1 | 0.063 4 | 0.079 6 | 0.072 6 | 0.085 2 | 0.068 1 | 0.102 7 | 0.091 0 | 0.097 6 | 0.11 62 | 0.1 08 7 |
| | (2 10 ) | 0.070 1 | 0.075 8 | 0.081 3 | 0.098 0 | 0.093 6 | 0.102 0 | 0.089 2 | 0.119 2 | 0.107 9 | 0.113 5 | 0.13 02 | 0.1 25 3 |
| | (2 11 ) | 0.087 9 | 0.095 6 | 0.101 8 | 0.125 6 | 0.117 9 | 0.132 8 | 0.112 3 | 0.155 6 | 0.139 8 | 0.148 5 | 0.16 95 | 0.1 63 2 |
| | (2 20 ) | | | | 0.134 7 | 0.128 6 | 0.140 9 | 0.121 6 | 0.164 3 | 0.147 7 | 0.156 2 | 0.17 86 | 0.1 72 1 |
| | (3 11 ) | | | | 0.143 5 | 0.137 1 | 0.151 2 | 0.130 0 | 0.170 9 | 0.156 3 | 0.162 8 | 0.19 19 | 0.1 82 6 |
| | (2 22 ) | | | | 0.154 3 | 0.148 6 | 0.160 7 | 0.141 2 | 0.181 2 | 0.167 2 | 0.171 3 | 0.20 03 | 0.1 94 1 |

Note: BCC+FCC in Table 2 means that both body-centered cubic packing and face-centered cubic close packing are included; and "--" indicates that the parameter is the same as F1.

EP 4 541 926 A1

Table 3

|  | Metal species in alloy | Lattice parameter k | Thickness/μm | $J_{H2}$ (Measured value) | $J_{H2}$ (Calculated value) |
|---|---|---|---|---|---|
| 1 | Pd and Cu | 0.2768 | 6 | 0.58 | 0.58 |
| 2 | Pd and Cu | 0.2832 | 6 | 0.55 | 0.57 |
| 3 | Pd and Cu | 0.2752 | 6 | 0.57 | 0.58 |
| 4 | Pd and Ag | 0.4125 | 7.5 | 0.36 | 0.37 |
| 5 | Pd and Ag | 0.4051 | 7.8 | 0.35 | 0.36 |
| 6 | Pd and Ag | 0.4146 | 8 | 0.34 | 0.35 |
| 7 | Pd and Ag | 0.4016 | 8.5 | 0.36 | 0.33 |
| 8 | Pd and Au | 0.4156 | 10 | 0.26 | 0.24 |
| 9 | Pd and Au | 0.4163 | 10 | 0.25 | 0.24 |
| 10 | Pd and Au | 0.4149 | 10 | 0.23 | 0.24 |
| 11 | Pd and Au | 0.4128 | 10 | 0.24 | 0.24 |
| 12 | Pd, Cu and Au | 0.4134 | 8 | 0.24 | 0.25 |
| 13 | Pd, Cu and Au | 0.417 | 9 | 0.23 | 0.22 |
| 14 | Pd, Cu and Au | 0.4098 | 8 | 0.26 | 0.25 |
| 15 | Pd, Cu and Au | 0.411 | 8 | 0.25 | 0.25 |
| 16 | Pd, Cu and Au | 0.4122 | 8 | 0.25 | 0.25 |
| 17 | Pd, Cu and Au | 0.4186 | 8 | 0.25 | 0.25 |
| 18 | Pd, Cu and Ag | 0.4072 | 10 | 0.33 | 0.32 |
| 19 | Pd, Cu and Ag | 0.4101 | 9 | 0.34 | 0.35 |
| 20 | Pd, Cu and Ag | 0.4025 | 10 | 0.34 | 0.32 |
| 21 | Pd, Cu and Ag | 0.4172 | 10 | 0.3 | 0.31 |
| 22 | Pd, Cu and Ag | 0.4144 | 10 | 0.31 | 0.32 |
| 23 | Pd and Cu | 0.289 | 6 | 0.56 | 0.56 |
| 24 | Pd and Cu | 0.2981 | 6 | 0.51 | 0.52 |
| 25 | Pd and Cu | 0.2955 | 6 | 0.52 | 0.54 |
| 26 | Pd, Cu and Ni | 0.2716 | 7.5 | 0.56 | 0.57 |
| 27 | Pd, Cu and Ni | 0.2755 | 8 | 0.55 | 0.53 |
| 28 | Pd, Cu and Ni | 0.2833 | 7.5 | 0.51 | 0.50 |
| 29 | Pd, Cu and Ni | 0.282 | 7.5 | 0.53 | 0.55 |

Note: when the alloy species is PdCu, b=1.89 during the calculation to obtain the corresponding calculated value, with a deviation of less than 10% from a measured value;

when the alloy species is PdAg, b=1.75 during the calculation to obtain the corresponding calculated value, with a deviation of less than 10% from a measured value;

when the alloy species is PdAu, b=2.01 during the calculation to obtain the corresponding calculated value, with a deviation of less than 10% from a measured value;

when the alloy species is PdCuAu, b=3.2 during the calculation to obtain the corresponding calculated value, with a deviation of less than 10% from a measured value;

when the alloy species is PdCuAg, b=2.02 during the calculation to obtain the corresponding calculated value, with a deviation of less than 10% from a measured value;

when the alloy species is PdCu, b=1.94 during the calculation to obtain the corresponding calculated value, with a deviation of less than 10% from a measured value; and when the alloy species is PdCuNi, b=2.10 during the calculation to obtain the corresponding calculated value, with a deviation of less than 10% from a measured value.

It should be noted that if the ratio of the metal components of the palladium membrane is not specifically indicated in each embodiment, a default ratio is an equal ratio (e.g., 1:1 or 1:1:1).

Further, the present invention establishes a database of the lattice parameter of the palladium membrane corresponding to the conditions of the alloying treatment through a large number of experiments, the hydrogen permeation rate of the palladium membrane is measured, and it is found that a certain relationship (e.g., the equation 5) is satisfied between the lattice parameter and the hydrogen permeation rate, and the hydrogen permeation rate calculated according to the equation 5 based on the lattice parameter is as shown in a column of "$J_{H2}$ (a calculated value)" in Table 3, and the deviation of the calculated value from the measured value is less than 10%. Based on this, convenient detection of the hydrogen permeation rate can be achieved. And when different hydrogen permeation rates are selected, the corresponding lattice parameter can be quickly determined by the formula shown in the equation 5, and then the lattice parameter is input into the database for screening, the conditions of the alloying treatment can be quickly determined, the period of the experiment is greatly shortened, and the efficiency of development or production is significantly improved.

The method of the present invention enables convenient detection of the hydrogen permeation rate by establishing a correspondence between the hydrogen permeation rate and the lattice parameter, has low requirements on input of equipment and raw materials and testing personnel, is simple and easy to implement, and has high accuracy. Furthermore, the corresponding conditions of the alloying treatment are selected based on different requirements, and thus a series of palladium membranes with excellent properties for different requirements, such as palladium membranes with good hydrogen separation performance, high mechanical strength, long service life and good stability, can be prepared in large quantities more conveniently.

In summary, the method of the present invention inventively first selects the one or more target palladium membranes for the hydrogen-related reaction according to a selection method for a target palladium membrane; then executes the hydrogen-related reaction with one of the one or more target palladium membranes, and thus, the method of the present invention can accurately control the progress of the hydrogen-related reaction so that its hydrogen permeation rate satisfies the target value.

An embodiment of the present invention provides a determination method for a permeation rate, including: a lattice parameter of a palladium membrane is measured; and a permeation rate of hydrogen passing through the palladium membrane is determined according to a lattice parameter, and metal components and a ratio thereof, and a thickness of the palladium membrane, and a correspondence between a permeation rate of hydrogen passing through a sample palladium membrane and a specific parameter set of the sample palladium membrane, wherein the specific parameter set includes a lattice parameter, a metal composition coefficient, and a thickness.

In particular, if the target palladium membrane is selected by the various embodiments described above or otherwise, the permeation rate of hydrogen passing through the target palladium membrane can be tested. First, a lattice parameter k' of a palladium membrane can be determined by X-ray diffraction analysis or atomic force microscopy analysis; then, a metal composition coefficient A' is determined according to metal components of the palladium membrane and a ratio thereof, for example, A' can be determined according to the metal components of the palladium membrane and the ratio thereof, in combination with the correspondence between the metal components and the ratio thereof and the metal composition coefficient; and next, a permeation rate $J_{H2}$' of hydrogen passing through the palladium membrane is determined according to k', A' and a thickness d' of the palladium membrane, in combination with a correspondence between a permeation rate of hydrogen passing through a sample palladium membrane and a specific parameter set of the sample palladium membrane (e.g., the one-to-one correspondence between the permeation rate $J_{H2}$, k, d, and A shown in Table 1).

In an embodiment, the correspondence between the permeation rate of the hydrogen passing through the sample palladium membrane and the specific parameter set of the sample palladium membrane includes:

$$J_{H2} = \frac{A}{k \times d}, \quad \text{Equation 1}$$

wherein $J_{H2}$ is a permeation rate of hydrogen passing through the sample palladium membrane; k is a lattice parameter of the sample palladium membrane; d is a thickness of the sample palladium membrane; and A is a metal composition coefficient of the sample palladium membrane.

If the target palladium membrane is selected by the various embodiments described above or otherwise, the permeation rate of hydrogen passing through the target palladium membrane can be tested. After the equation 1 is obtained, first, a lattice parameter k' of a palladium membrane can be determined by X-ray diffraction analysis or atomic force microscopy analysis; then, a metal composition coefficient A' is determined according to metal components of the palladium membrane and a ratio thereof, for example, A' can be determined according to the metal components of the palladium membrane and the ratio thereof, in combination with the correspondence between the metal components and the ratio thereof and the metal composition coefficient; and next, by substituting k', A' and a thickness d' of the palladium membrane into the above equation 1, a permeation rate $J_{H2}$' of hydrogen passing through the palladium membrane can be determined.

In particular, A depends on the number of metal species of the sample palladium membrane, a relative atomic mass and a density of each metal, and an average relative atomic mass and an average density of the sample palladium membrane.

For example, A is determined by:

$$A = (n-1)! \times \frac{\left[\frac{M_a^n}{\Sigma_i^n M_i}\right]^{\frac{1}{n}} \times \left[\frac{\Sigma_i^n \rho_i}{\rho_a^n}\right]^{\frac{1}{n}}}{10^5}, \quad \text{Equation 2}$$

wherein n is the number of metal species of the sample palladium membrane, $M_i$ and $\rho_i$ are a relative atomic mass and a density of an ith metal of the sample palladium membrane, respectively, and $M_a$ and $\rho_a$ are an average relative atomic mass and an average density of the sample palladium membrane, respectively.

Of course, A is not limited to adopt the above equation 2, and may also adopt a reasonable variation of the above equation 2. For example, on the basis of the equation 2, a weight coefficient w is multiplied. In particular, w may be a value close to 1.

If the target palladium membrane is selected by the various embodiments described above or otherwise, the permeation rate of hydrogen passing through the target palladium membrane can be tested. First, a metal composition coefficient A' can be obtained by the equation 2 according to metal components of the target palladium membrane and a ratio thereof. Next, after a lattice parameter k' of a palladium membrane can be determined by X-ray diffraction analysis or atomic force microscopy analysis, a permeation rate $J_{H2}$' of hydrogen passing through the palladium membrane can be determined by substituting k', A' and a thickness d' of the palladium membrane into the equation 1.

In another embodiment, the above equation 1 can be further optimized to add a correction coefficient that is related to the metal components of the sample palladium membrane.

The correspondence between the permeation rate of the hydrogen passing through the sample palladium membrane and the specific parameter set of the sample palladium membrane includes:

$$J_{H2} = \frac{A}{b \times k \times d}, \quad \text{Equation 3}$$

wherein $J_{H2}$ is a permeation rate of hydrogen passing through the sample palladium membrane; k is a lattice parameter of the sample palladium membrane; d is a thickness of the sample palladium membrane; A is a metal composition coefficient of the sample palladium membrane; and b is a correction coefficient.

In particular, A depends on the number of metal species of the sample palladium membrane, a relative atomic mass and a density of each metal, and an average relative atomic mass and an average density of the sample palladium membrane.

For example, A is determined by:

$$A = (n-1)! \times \left[\frac{M_a^n}{\Sigma_i^n M_i}\right]^{\frac{1}{n}} \times \left[\frac{\Sigma_i^n \rho_i}{\rho_a^n}\right]^{\frac{1}{n}} / 10^5 \quad \text{Equation 4}$$

wherein n is the number of metal species of the sample palladium membrane, $M_i$ and $\rho_i$ are a relative atomic mass and a density of an ith metal of the sample palladium membrane, respectively, and $M_a$ and $\rho_a$ are an average relative atomic mass and an average density of the sample palladium membrane, respectively.

Of course, A is not limited to adopt the above equation 4, and may also adopt a reasonable variation of the above equation 4. For example, on the basis of the equation 4, a weight coefficient w is multiplied. In particular, w may be a value close to 1.

In the case where the target lattice parameter and the target metal composition coefficient are selected, the target metal components and the ratio thereof can be obtained by the equation 4.

In particular, b depends on an effective atomic radius of the sample palladium membrane. b is in the range of 1-5, and a specific situation of a value range of b with different materials can refer to the above relevant description of the selection method for the target palladium membrane.

If the target palladium membrane is selected by the various embodiments described above or otherwise, the permeation rate of hydrogen passing through the target palladium membrane can be tested. First, a metal composition coefficient A' can be obtained by the equation 4 according to metal components of the target palladium membrane and a ratio thereof. Next, after a lattice parameter k' of a palladium membrane can be determined by X-ray diffraction analysis or atomic force microscopy analysis, a permeation rate $J_{H2}'$ of hydrogen passing through the palladium membrane can be determined by substituting k', A' and a thickness d' of the palladium membrane into the equation 3.

The inventors of the present invention found during research that there is a certain correlation between the hydrogen permeation rate and the lattice parameter of the palladium membrane, and the lattice parameter can be measured by a single instrument, the process is simple, and the demands on testing personnel are also low, so that determining the hydrogen permeation rate by the lattice parameter will greatly simplify a process of testing the hydrogen permeation rate of the palladium membrane.

In summary, the method of the present invention inventively first measures the lattice parameter of the palladium membrane; then determines the permeation rate of the hydrogen passing through the palladium membrane according to the lattice parameter, and the metal components and the ratio thereof, and the thickness of the palladium membrane, and the correspondence between the permeation rate of the hydrogen passing through the sample palladium membrane and the specific parameter set of the sample palladium membrane. Thus, the method of the present invention can efficiently and accurately determine the hydrogen permeation rate of the palladium membrane under non-destructive treatment conditions.

An embodiment of the present invention provides a selection system for a target palladium membrane, including: a memory configured to store a target permeation rate of hydrogen passing through the target palladium membrane, a target thickness of the target palladium membrane, and a correspondence between a permeation rate of hydrogen passing through a sample palladium membrane and a specific parameter set of the sample palladium membrane, wherein the specific parameter set includes a lattice parameter, a metal composition coefficient, and a thickness; and a processor configured to: determine a target lattice parameter, and target metal components and a ratio thereof of the target palladium membrane according to the target permeation rate, the target thickness, and the correspondence; and select a palladium membrane having the target lattice parameter, the target metal components and the ratio thereof, and the target thickness to be the target palladium membrane.

Specific details and benefits of the selection system for the target palladium membrane provided by the present invention can refer to the above description of the selection method for the target palladium membrane, which will not be repeated here.

An embodiment of the present invention provides an execution system for a hydrogen-related reaction, including: the selection system for the target palladium membrane, configured to select one or more target palladium membranes for the hydrogen-related reaction, wherein a permeation rate of hydrogen passing through any one of the one or more target palladium membranes is a target permeation rate; and an execution device configured to execute the hydrogen-related reaction with one of the one or more target palladium membranes.

Wherein the execution device may include a hydrogenation reactor, a dehydrogenation reactor or a hydrogen production reactor. The execution device may also include a desulfurization and denitrification tower, a light component removal tower, a heavy component removal tower, a fractionation tower, a catalyst tank, a hydrogen storage tank, a heat exchanger, a hydrogen transport pipeline, a mechanical pump, a steam pipe network, and/or a large-scale unit (a flue gas turbine, a fan, a compressor, etc.).

Specific details and benefits of the execution system for the hydrogen-related reaction provided by the present invention can refer to the above description of the execution method for the hydrogen-related reaction, which will not be repeated here.

An embodiment of the present invention provides a determination system for a permeation rate, including: a measuring device configured to measure a lattice parameter of a palladium membrane; a memory configured to store metal components and a ratio thereof, and a thickness of the palladium membrane; and a processor configured to determine a permeation rate of hydrogen passing through the palladium membrane according to the lattice parameter, and the metal components and the ratio thereof, and the thickness of the palladium membrane, and a correspondence between a permeation rate of hydrogen passing through a sample palladium membrane and a specific parameter set of the sample palladium membrane, wherein the specific parameter set includes a lattice parameter, a metal composition coefficient, and a thickness.

Specific details and benefits of the determination system for the permeation rate provided by the present invention can refer to the above description of the determination method for the permeation rate, which will not be repeated here.

An embodiment of the present invention provides a computer-readable storage medium, having stored thereon a computer program which, when executed by a processor, implements a selection method for a target palladium membrane for a hydrogen-related reaction, a execution method for a hydrogen-related reaction and/or a determination method for a permeation rate.

The endpoints and any values of the ranges disclosed herein are not limited to the precise range or value, and these ranges or values should be understood as including values close to these ranges or values. For numerical ranges, the endpoint values of each range, the endpoint values of each range and individual point values, and individual point values may be combined with each other to obtain one or more new numerical ranges, and these numerical ranges should be considered to be specifically disclosed herein.

Optional implementations of the embodiments of the present invention are described in detail above in conjunction with the accompanying drawings, however, the embodiments of the present invention are not limited to the specific details in the above embodiments, and many simple variations can be made to the technical solutions of the embodiments of the present invention within the scope of the technical idea of the embodiments of the present invention, and these simple variations all belong to the protection scope of the embodiments of the present invention.

In addition, it should be noted that the specific technical features described in the above specific embodiments can be combined in any appropriate mode without contradiction. In order to avoid unnecessary repetition, various possible combinations are not described any more in the embodiments of the present invention.

Those skilled in the art will appreciate that all or part of the steps in the method implementing the embodiments described above may be performed by instructing related hardware through a program, the program is stored in a storage medium and includes a plurality of instructions configured to cause a single chip microcomputer, a chip or a processor to perform all or part of the steps of the method according to the embodiments of the present application. The aforementioned storage medium includes various media capable of storing program codes, such as a USB flash disk, a mobile hard disk, a Read-Only Memory (ROM), a Random Access Memory (RAM), a magnetic disk, or an optical disk.

In addition, any combination between various implementations of the embodiments of the present invention may be made, and as long as they do not depart from the idea of the embodiments of the present invention, they should also be considered as the contents disclosed in the embodiments of the present invention.

**Claims**

1. A selection method for a target palladium membrane, **characterized by** comprising:

   determining a target lattice parameter, and target metal components and a ratio thereof of the target palladium membrane according to a target permeation rate of hydrogen passing through the target palladium membrane, a target thickness of the target palladium membrane, and a correspondence between a permeation rate of hydrogen passing through a sample palladium membrane and a specific parameter set of the sample palladium membrane, wherein the specific parameter set comprises a lattice parameter, a metal composition coefficient and a thickness; and
   selecting a palladium membrane having the target lattice parameter, the target metal components and the ratio thereof, and the target thickness to be the target palladium membrane.

2. The selection method according to claim 1, **characterized in that** the correspondence between the permeation rate of the hydrogen passing through the sample palladium membrane and the specific parameter set of the sample palladium membrane comprises:

$$J_{H2} = \frac{A}{k \times d},$$

   wherein $J_{H2}$ is the permeation rate of the hydrogen passing through the sample palladium membrane; k is a lattice parameter of the sample palladium membrane; d is a thickness of the sample palladium membrane; and A is a metal composition coefficient of the sample palladium membrane.

3. The selection method according to claim 1, **characterized in that** the correspondence between the permeation rate of the hydrogen passing through the sample palladium membrane and the specific parameter set of the sample palladium membrane comprises:

$$J_{H2} = \frac{A}{b \times k \times d},$$

   wherein $J_{H2}$ is the permeation rate of the hydrogen passing through the sample palladium membrane; k is a lattice parameter of the sample palladium membrane; d is a thickness of the sample palladium membrane; A is a metal composition coefficient of the sample palladium membrane; and b is a correction coefficient.

4. The selection method according to claim 2 or 3, **characterized in that** A depends on the number of metal species of the sample palladium membrane, a relative atomic mass and a density of each metal, and an average relative atomic mass and an average density of the sample palladium membrane.

5. The selection method according to claim 4, **characterized in that** A is determined by:

$$A = (n-1)! \times \frac{\left[\frac{M_a^n}{\sum_i^n M_i}\right]^{\frac{1}{n}} \times \left[\frac{\sum_i^n \rho_i}{\rho_a^n}\right]^{\frac{1}{n}}}{10^5},$$

wherein n is the number of metal species of the sample palladium membrane, $M_i$ and $\rho_i$ are a relative atomic mass and a density of an ith metal of the sample palladium membrane, respectively, and $M_a$ and $\rho_a$ are an average relative atomic mass and an average density of the sample palladium membrane, respectively.

6. The selection method according to claim 3, **characterized in that** b depends on an effective atomic radius of the sample palladium membrane.

7. The selection method according to claim 6, **characterized in that** in a case where a material of the sample palladium membrane is a PdCu alloy, b is in the range of 1.01-2.51;

in a case where a material of the sample palladium membrane is a PdAg alloy, b is in the range of 1.12-2.53;
in a case where a material of the sample palladium membrane is a PdAu alloy, b is in the range of 1.56-3.62;
in a case where a material of the sample palladium membrane is a PdCuAg alloy, b is in the range of 1.93-3.69;
in a case where a material of the sample palladium membrane is a PdCuAu alloy, b is in the range of 2.56-4.99; or
in a case where a material of the sample palladium membrane is a PdCuNi alloy, b is in the range of 1.63-2.71.

8. An execution method for a hydrogen-related reaction, **characterized by** comprising:

selecting one or more target palladium membranes for the hydrogen-related reaction by a selection method for a target palladium membrane according to any one of claims 1-7, wherein a permeation rate of hydrogen passing through any one of the one or more target palladium membranes is a target permeation rate; and
executing the hydrogen-related reaction with one of the one or more target palladium membranes.

9. The execution method according to claim 8, **characterized in that** the hydrogen-related reaction is a reaction in which hydrogen, oxygen and propene are used as substrates to synthesize propylene oxide;

the hydrogen-related reaction is a reaction in which hydrogen and oxygen are used as substrates to synthesize hydrogen peroxide;
the hydrogen-related reaction is a reaction for hydrogen production by steam reforming of alcohol and water;
the hydrogen-related reaction is a carbon dioxide hydrogenation reaction;
the hydrogen-related reaction is a reaction in which hydrogen and nitrogen are used as substrates to synthesize ammonia gas;
the hydrogen-related reaction is a reaction in which ethane is dehydrogenated to prepare ethylene;
the hydrogen-related reaction is a reaction in which propane is dehydrogenated to prepare propylene;
the hydrogen-related reaction is a reaction in which butane is dehydrogenated to form butadiene;
the hydrogen-related reaction is a reaction in which isopentene is dehydrogenated to form isoprene;
the hydrogen-related reaction is a reaction in which ethylbenzene is dehydrogenated to prepare styrene;
the hydrogen-related reaction is a reaction in which isobutane is dehydrogenated to prepare isobutylene;
the hydrogen-related reaction is a reaction in which benzene is hydrogenated to prepare cyclohexane;
the hydrogen-related reaction is a reaction in which benzene, hydrogen, and oxygen are used as substrates to prepare phenol;
the hydrogen-related reaction is a reaction in which carbon monoxide is hydrogenated to prepare methanol;
the hydrogen-related reaction is a reaction in which phenol is hydrogenated to prepare cyclohexanol;
the hydrogen-related reaction is a reaction in which nitrobenzene is subjected to hydrogenation reduction to prepare aniline; or
the hydrogen-related reaction is a reaction in which butane is dehydrogenated to form butadiene.

10. The execution method according to claim 8, **characterized in that** the target palladium membrane is prepared by:

performing alloying treatment on a palladium membrane raw material under different conditions of the alloying treatment, measuring a lattice parameter of a product, and establishing a fitting curve of a correspondence between conditions of the alloying treatment and the lattice parameter;
determining a target condition of the alloying treatment according to a lattice parameter of the target palladium membrane and the fitting curve; and
performing alloying treatment on the palladium membrane raw material by using the target condition to obtain the target palladium membrane.

11. A determination method for a permeation rate, **characterized by** comprising:

measuring a lattice parameter of a palladium membrane; and
determining a permeation rate of hydrogen passing through the palladium membrane according to a lattice parameter, and metal components and a ratio thereof, and a thickness of the palladium membrane, and a correspondence between a permeation rate of hydrogen passing through a sample palladium membrane and a specific parameter set of the sample palladium membrane, wherein the specific parameter set comprises a lattice parameter, a metal composition coefficient, and a thickness.

12. The determination method according to claim 11, **characterized in that** the correspondence between the permeation rate of the hydrogen passing through the sample palladium membrane and the specific parameter set of the sample palladium membrane comprises:

$$J_{H2} = \frac{A}{k \times d},$$

wherein $J_{H2}$ is the permeation rate of the hydrogen passing through the sample palladium membrane; k is a lattice parameter of the sample palladium membrane; d is a thickness of the sample palladium membrane; and A is a metal composition coefficient of the sample palladium membrane.

13. The determination method according to claim 11, **characterized in that** the correspondence between the permeation rate of the hydrogen passing through the sample palladium membrane and the specific parameter set of the sample palladium membrane comprises:

$$J_{H2} = \frac{A}{b \times k \times d},$$

wherein $J_{H2}$ is the permeation rate of the hydrogen passing through the sample palladium membrane; k is a lattice parameter of the sample palladium membrane; d is a thickness of the sample palladium membrane; A is a metal composition coefficient of the sample palladium membrane; and b is a correction coefficient.

14. The determination method according to claim 12 or 13, **characterized in that** A depends on the number of metal species of the sample palladium membrane, a relative atomic mass and a density of each metal, and an average relative atomic mass and an average density of the sample palladium membrane.

15. The determination method according to claim 14, **characterized in that** A is determined by:

$$A = (n-1)! \times \frac{\left[\frac{M_a^n}{\sum_i^n M_i}\right]^{\frac{1}{n}} \times \left[\frac{\sum_i^n \rho_i}{\rho_a^n}\right]^{\frac{1}{n}}}{10^5},$$

wherein n is the number of metal species of the sample palladium membrane, $M_i$ and $\rho_i$ are a relative atomic mass and a density of an ith metal of the sample palladium membrane, respectively, and $M_a$ and $\rho_a$ are an average relative atomic mass and an average density of the sample palladium membrane, respectively.

16. The determination method according to claim 13, **characterized in that** b depends on an effective atomic radius of the sample palladium membrane.

17. A selection system for a target palladium membrane, **characterized by** comprising:

a memory configured to store a target permeation rate of hydrogen passing through the target palladium membrane, a target thickness of the target palladium membrane, and a correspondence between a permeation rate of hydrogen passing through a sample palladium membrane and a specific parameter set of the sample palladium membrane, wherein the specific parameter set comprises a lattice parameter, a metal composition coefficient, and a thickness; and
a processor configured to:

determine a target lattice parameter, and target metal components and a ratio thereof of the target palladium membrane according to the target permeation rate, the target thickness and the correspondence; and
select a palladium membrane having the target lattice parameter, the target metal components and the ratio thereof, and the target thickness to be the target palladium membrane.

18. An execution system for a hydrogen-related reaction, **characterized by** comprising:

a selection system for a target palladium membrane according to claim 17, configured to select one or more target palladium membranes for the hydrogen-related reaction, wherein a permeation rate of hydrogen passing through any one of the one or more target palladium membrane is a target permeation rate; and
an execution device, configured to execute the hydrogen-related reaction with one of the one or more target palladium membranes.

19. A determination system for a permeation rate, **characterized by** comprising:

a measuring device configured to measure a lattice parameter of a palladium membrane;
a memory configured to store metal components and a ratio thereof, and a thickness of the palladium membrane; and
a processor configured to determine a permeation rate of hydrogen passing through the palladium membrane according to the lattice parameter, and the metal components and the ratio thereof, and the thickness of the palladium membrane, and a correspondence between a permeation rate of hydrogen passing through a sample palladium membrane and a specific parameter set of the sample palladium membrane, wherein the specific parameter set comprises a lattice parameter, a metal composition coefficient, and a thickness.

20. A computer-readable storage medium, **characterized by** having stored thereon a computer program, which, when executed by a processor, implements a selection method for a target palladium membrane for a hydrogen-related reaction according to any one of claims 1-7, a execution method for a hydrogen-related reaction according to any one of claims 8-10 and/or a determination method for a permeation rate according to any one of claims 11-16.

S101 — A target lattice parameter, and target metal components and a ratio thereof of the target palladium membrane are determined according to a target permeation and diffusion rate of hydrogen passing through the target palladium membrane, a target thickness of the target palladium membrane, and a correspondence between a permeation and diffusion rate of hydrogen passing through a sample palladium membrane and a specific parameter set of the sample palladium membrane

S102 — A palladium membrane having the target lattice parameter, the target metal components and the ratio thereof, and the target thickness is selected to be the target palladium membrane

FIG. 1

<table>
<tr><td colspan="2" align="center">**INTERNATIONAL SEARCH REPORT**</td><td>International application No.<br><br>**PCT/CN2023/107040**</td></tr>
</table>

| A. | CLASSIFICATION OF SUBJECT MATTER |
|---|---|
| | C23C14/16(2006.01)i |

According to International Patent Classification (IPC) or to both national classification and IPC

| B. | FIELDS SEARCHED |
|---|---|

Minimum documentation searched (classification system followed by classification symbols)

C23C14/-

Documentation searched other than minimum documentation to the extent that such documents are included in the fields searched

Electronic data base consulted during the international search (name of data base and, where practicable, search terms used)

CNTXT, WPABSC, ENTXTC, CNKI, VCN, ENTXT, VEN: 中国石油化工股份有限公司, 中石化安全工程研究院有限公司, 赵辰阳, 孙冰, 刘聿嘉, 姜杰, 朱云峰, 徐伟, 杨哲, 钯, 膜, 扩散, 渗透, 速度, 速率, 厚度, 晶格, 晶包, 组分, 成分, 目标, 所需, 选择, 选用, palladium, membrane?, film?, diffusion, permeat+, speed, velocity, thickness, crystal, component?, constituen+.

| C. | DOCUMENTS CONSIDERED TO BE RELEVANT |
|---|---|

| Category* | Citation of document, with indication, where appropriate, of the relevant passages | Relevant to claim No. |
|---|---|---|
| A | US 2003190486 A1 (COLORADO SCHOOL OF MINES) 09 October 2003 (2003-10-09)<br>claim 9 | 1-20 |
| A | CN 101555594 A (DALIAN INSTITUTE OF CHEMICAL PHYSICS, CHINESE ACADEMY OF SCIENCES) 14 October 2009 (2009-10-14)<br>entire document | 1-20 |
| A | CN 103721576 A (NANJING TECH UNIVERSITY) 16 April 2014 (2014-04-16)<br>entire document | 1-20 |
| A | CN 104342617 A (PEKING UNIVERSITY) 11 February 2015 (2015-02-11)<br>entire document | 1-20 |
| A | KR 20100129123 A (KYONGGI UNIVERSITY INDUSTRY & ACADEMIA COOPERATION FOUNDATION et al.) 08 December 2010 (2010-12-08)<br>entire document | 1-20 |
| A | US 4684581 A (STRUTHERS RALPH C.) 04 August 1987 (1987-08-04)<br>entire document | 1-10 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **19 October 2023** | **23 October 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

INTERNATIONAL SEARCH REPORT
Information on patent family members

International application No.

**PCT/CN2023/107040**

| Patent document cited in search report | | | Publication date (day/month/year) | Patent family member(s) | | | Publication date (day/month/year) |
|---|---|---|---|---|---|---|---|
| US | 2003190486 | A1 | 09 October 2003 | EP | 1499452 | A2 | 26 January 2005 |
| | | | | EP | 1499452 | A4 | 05 July 2006 |
| | | | | EP | 1499452 | B1 | 18 December 2013 |
| | | | | WO | 03084628 | A2 | 16 October 2003 |
| | | | | WO | 03084628 | A3 | 10 June 2004 |
| | | | | AU | 2003221816 | A1 | 20 October 2003 |
| | | | | US | 2006188737 | A1 | 24 August 2006 |
| | | | | US | 8119205 | B2 | 21 February 2012 |
| | | | | AU | 2003221816 | A8 | 20 October 2003 |
| CN | 101555594 | A | 14 October 2009 | CN | 101555594 | B | 01 December 2010 |
| CN | 103721576 | A | 16 April 2014 | CN | 103721576 | B | 26 October 2016 |
| CN | 104342617 | A | 11 February 2015 | | None | | |
| KR | 20100129123 | A | 08 December 2010 | KR | 101176585 | B1 | 23 August 2012 |
| US | 4684581 | A | 04 August 1987 | | None | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210843326